(19) Europäisches Patentamt
European Patent Office
Office européen des brevets

(11) **EP 4 475 105 A1**

(12) **EUROPEAN PATENT APPLICATION**

(43) Date of publication:
**11.12.2024 Bulletin 2024/50**

(21) Application number: **24174787.2**

(22) Date of filing: **08.05.2024**

(51) International Patent Classification (IPC):
**G08G 1/01** *(2006.01)*

(52) Cooperative Patent Classification (CPC):
**G08G 1/0116; G08G 1/0133;** G08G 1/0145

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.05.2023 JP 2023087326**

(71) Applicant: **FUJITSU LIMITED**
**Kawasaki-shi, Kanagawa 211-8588 (JP)**

(72) Inventors:
• **CHEN, Bin**
**Kawasaki-shi, Kanagawa, 211-8588 (JP)**
• **SEGAWA, Eigo**
**Kawasaki-shi, Kanagawa, 211-8588 (JP)**

(74) Representative: **Hoffmann Eitle**
**Patent- und Rechtsanwälte PartmbB**
**Arabellastraße 30**
**81925 München (DE)**

(54) **OD DETERMINATION METHOD AND OD DETERMINATION PROGRAM**

(57) An origin destination (OD) determination method includes: performing a first traffic simulation that estimates a traffic volume for each link included in a path from a first point to a second point, by using a first OD traffic volume that has departed from the first point and reached the second point in a first time frame, for each first time frame obtained by dividing a target period; determining an OD traffic volume for each first time frame, for a pair of the first point and the second point, by repeatedly performing the first traffic simulation while adjusting the first OD traffic volume, so as to reduce an error between the estimated traffic volume of the link and a traffic volume observed for the link; calculating a second OD traffic volume that has departed from the first point and reached the second point in a second time frame, for each second time frame obtained by dividing the first time frame, based on the determined OD traffic volume for each first time frame; performing a second traffic simulation that estimates a traffic volume for each link, for each second time frame, by using the calculated second OD traffic volume; and determining an OD traffic volume for each second time frame, for the pair of the first point and the second point, by repeatedly performing the second traffic simulation while adjusting the second OD traffic volume, so as to reduce an error between the estimated traffic volume of the link and a traffic volume observed for the link.

FIG. 1

**Description**

FIELD

The embodiment discussed herein is related to an origin destination (OD) determination method and an OD determination program.

BACKGROUND

In recent years, various traffic measures have been studied in local governments, companies, or the like in order to achieve, for example, reduction of traffic congestions in urban areas and reduce $CO_2$ emissions due to traffic. For example, various traffic situations are reproduced on a digital twin, and measure effects are evaluated by estimating a traffic movement demand. The traffic movement demand is, for example, represented by an OD traffic volume such as the number of vehicles that have departed from an Origin (origin) and reached Destination (destination).

There is related art that estimates an OD traffic volume based on probe information and statistical information, simulates a traffic state based on road network information, signal information, and the estimated OD traffic volume, corrects the OD traffic volume so as to reduce a difference between a calculated value of the traffic volume of the link calculated based on the simulated traffic state and a target value of the traffic volume of the link, and simulates the traffic state using the corrected OD traffic volume.

Japanese Laid-open Patent Publication No. 2009-259158 is disclosed as related art.

SUMMARY

TECHNICAL PROBLEM

However, in the related art, there is a case where it takes an enormous processing time to estimate an OD traffic volume (traffic movement demand).

In one aspect, an object of the embodiment is to shorten a processing time taken to estimate an OD traffic volume.

An origin destination (OD) determination method includes: performing a first traffic simulation that estimates a traffic volume for each link included in a path from a first point to a second point, by using a first OD traffic volume that has departed from the first point and reached the second point in a first time frame, for each first time frame obtained by dividing a target period; determining an OD traffic volume for each first time frame, for a pair of the first point and the second point, by repeatedly performing the first traffic simulation while adjusting the first OD traffic volume, so as to reduce an error between the estimated traffic volume of the link and a traffic volume observed for the link; calculating a second OD traffic volume that has departed from the first point and reached the second point in a second time frame, for each second time frame obtained by dividing the first time frame, based on the determined OD traffic volume for each first time frame; performing a second traffic simulation that estimates a traffic volume for each link, for each second time frame, by using the calculated second OD traffic volume; and determining an OD traffic volume for each second time frame, for the pair of the first point and the second point, by repeatedly performing the second traffic simulation while adjusting the second OD traffic volume, so as to reduce an error between the estimated traffic volume of the link and a traffic volume observed for the link.

ADVANTAGEOUS EFFECTS OF INVENTION

According to one aspect of the embodiment, an effect is obtained that a processing time taken to estimate an OD traffic volume can be shortened.

BRIEF DESCRIPTION OF DRAWINGS

FIG. 1 is an explanatory diagram illustrating an example of an OD determination method according to an embodiment;
FIG. 2 is an explanatory diagram illustrating a system configuration example of an information processing system 200;
FIG. 3 is a block diagram illustrating a hardware configuration example of an OD estimation device 201;
FIG. 4 is an explanatory diagram illustrating a specific example of a road network;
FIG. 5 is an explanatory diagram illustrating a specific example of a road network table;
FIG. 6 is an explanatory diagram illustrating a specific example of an origin table;
FIG. 7 is an explanatory diagram illustrating a specific example of a destination table;

FIG. 8 is an explanatory diagram illustrating a specific example of an OD pair table;
FIG. 9 is an explanatory diagram illustrating a specific example of a path table;
FIG. 10 is a block diagram illustrating a functional configuration example of the OD estimation device 201;
FIG. 11 is an explanatory diagram illustrating a calculation example of a second OD flow;
FIG. 12 is an explanatory diagram illustrating a first operation example of the OD estimation device 201;
FIG. 13 is an explanatory diagram illustrating a specific example of an initial OD flow;
FIG. 14 is an explanatory diagram (part 1) illustrating a specific example of a path selection table;
FIG. 15 is an explanatory diagram (part 1) illustrating a specific example of a link flow (ratio);
FIG. 16 is an explanatory diagram (part 1) illustrating a specific example of a link flow (traffic volume);
FIG. 17 is an explanatory diagram (part 1) illustrating an example of an observation matrix;
FIG. 18 is an explanatory diagram (part 1) illustrating a specific example of an observable link flow (traffic volume);
FIG. 19 is an explanatory diagram (part 1) illustrating a specific example of an error of the link flow (traffic volume);
FIG. 20 is an explanatory diagram (part 1) illustrating an update example of an OD flow;
FIG. 21 is an explanatory diagram illustrating an OD flow estimation result in a coarse time frame;
FIG. 22 is an explanatory diagram illustrating a second operation example of the OD estimation device 201;
FIG. 23 is an explanatory diagram illustrating a distribution example of the OD flow;
FIG. 24 is an explanatory diagram (part 2) illustrating a specific example of the path selection table;
FIG. 25 is an explanatory diagram (part 2) illustrating a specific example of the link flow (ratio);
FIG. 26 is an explanatory diagram (part 2) illustrating a specific example of the link flow (traffic volume);
FIG. 27 is an explanatory diagram (part 2) illustrating an example of the observation matrix;
FIG. 28 is an explanatory diagram (part 2) illustrating a specific example of the observable link flow (traffic volume);
FIG. 29 is an explanatory diagram (part 2) illustrating a specific example of the error of the link flow (traffic volume);
FIG. 30 is an explanatory diagram (part 2) illustrating the update example of the OD flow;
FIG. 31 is an explanatory diagram illustrating an OD flow estimation result in a fine time frame;
FIG. 32 is a flowchart (part 1) illustrating an example of an OD determination processing procedure of the OD estimation device 201; and
FIG. 33 is a flowchart (part 2) illustrating an example of the OD determination processing procedure of the OD estimation device 201.

## DESCRIPTION OF EMBODIMENTS

Hereinafter, an embodiment of an OD determination method and an OD determination program will be described in detail with reference to the drawings.

(Embodiment)

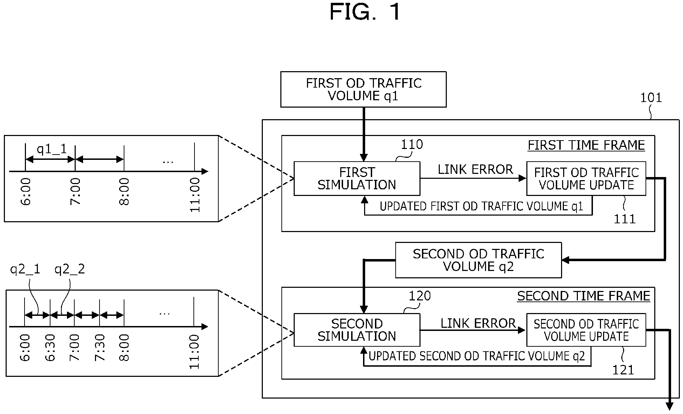

FIG. 1 is an explanatory diagram illustrating an example of an OD determination method according to an embodiment. In FIG. 1, an information processing device 101 is a computer that determines an OD traffic volume for each designated time frame, for a pair of an origin and a destination.

Here, the OD traffic volume is an index representing a traffic movement demand and represents a traffic volume from the origin to the destination in a certain time frame. The OD traffic volume is estimated, for example, using a traffic simulation. The time frame is a time section (time slot) obtained by dividing a certain period at equal intervals. The traffic volume is represented, for example, by the number of vehicles or the number of people.

An existing traffic demand estimation technique is, for example, a technique (related art 1) for estimating the OD traffic volume for each time frame, using the traffic simulation. The traffic simulation is, for example, to reproduce a traffic phenomenon occurring on a road with a computer and simulate how a traffic situation such as a traffic congestion or a traffic disturbance changes.

First, the related art 1 performs a traffic simulation using an OD traffic volume given as an initial value and estimates the number of vehicles that have passed through each link on a path from an origin to a destination. Next, the related art 1 updates the OD traffic volume based on an error between the estimated number of vehicles that have passed through the link and the number of vehicles that have passed through the link and have been actually observed.

Then, the related art 1 performs the traffic simulation again, using the updated OD traffic volume. The related art 1 repeatedly executes this series of processing (traffic simulation → update of OD traffic volume → traffic simulation) until the error of the number of vehicles that have passed through the link falls within a predetermined range.

In this way, the related art 1 estimates the OD traffic volume for each time frame. The time frame is, for example, a time section for every 15 minutes or 30 minutes. Note that, regarding the related art 1, Non-Patent Document 1 can be referred.

Non-Patent Document 1: Wei Ma, Xidong Pi, Sean Qian: Estimating multi-class dynamic origin-destination demand through a forward-backward algorithm on computational graphs, Transportation Research Part C 119(2020)102747.

However, in the related art 1, there is a case where it takes an enormous processing time to estimate an OD traffic volume for each time frame (for example, for each 30 minutes, 15 minutes, or the like). In the related art 1, a size of a matrix used to estimate the OD traffic volume increases in a square depending on the number of nodes, the number of links, the number of OD pairs, and the number of moving paths in a road network. Furthermore, in the related art 1, in a case where an OD traffic volume in a fine time frame obtained by dividing time is needed, the matrix size is multiplied by a square of the number of time frames, and it takes an enormous processing time to estimate the OD traffic volume.

Therefore, in the present embodiment, an OD determination method will be described for reducing the number of repetitions of a traffic simulation and shortening a processing time before an optimal solution is obtained when the OD traffic volume for each time frame is estimated. Here, processing examples (corresponding processing (1) to (5) below) of the information processing device 101 will be described.

(1) The information processing device 101 performs a first simulation 110, using a first OD traffic volume q1. Here, the first simulation 110 is a traffic simulation for estimating a traffic volume for each link included in a path from a first point to a second point, for each first time frame obtained by dividing a target period.

The first point corresponds to the origin. The second point corresponds to the destination. The path from the origin to the destination is represented, for example, by the road network. The road network is information regarding a road net and is a network using an intersection as a node and a road between the intersections as a link.

The first OD traffic volume q1 represents an OD traffic volume for departing the first point and reaching the second point in the first time frame, for each first time frame obtained by dividing the target period. The first OD traffic volume q1 may be, for example, a predetermined constant or may be represented by a randomly generated random number. The target period can be arbitrarily set and is set to, for example, a period from 6:00 to 11:00 or the like. Furthermore, a time width of the first time frame can be arbitrarily set and is set to, for example, one hour or the like.

(2) The information processing device 101 repeatedly performs the first simulation 110 while adjusting the first OD traffic volume q1, so as to reduce the error between the estimated traffic volume of the link and the observed traffic volume for the link. As a result, the information processing device 101 determines the OD traffic volume for each first time frame, for a pair of the first point and the second point.

Specifically, for example, the information processing device 101 calculates the error between the estimated traffic volume of the link and the observed traffic volume for the link. In a case where the calculated error is larger than a threshold, the information processing device 101 updates the first OD traffic volume q1 based on the calculated error (reference numeral 111 in FIG. 1). The threshold can be arbitrarily set.

Then, the information processing device 101 performs the first simulation 110 using the updated first OD traffic volume q1. On the other hand, in a case where the calculated error is equal to or less than the threshold, the information processing device 101 determines the first OD traffic volume q1 used for the immediately preceding first simulation 110 as the OD traffic volume for each first time frame.

(3) The information processing device 101 calculates a second OD traffic volume q2 for departing the first point and reaching the second point in a second time frame, for each second time frame obtained by dividing the first time frame, based on the determined OD traffic volume for each first time frame. A time width of the second time frame can be arbitrarily set according to the time width of the first time frame and is set, for example, to 30 minutes or the like.

For example, the target period is set to "6:00 to 11:00". Furthermore, the first time frame is set to each time section obtained by dividing °6:00 to 11:00" by one hour. In this case, the second time frame is set, for example, to each time section (for example, 6:00 to 6:30) obtained by dividing each first time frame by each 30 minutes.

Specifically, for example, the information processing device 101 calculates the second OD traffic volume q2 by distributing the determined first OD traffic volume q1 for each second time frame according to a predetermined ratio. The predetermined ratio is set, for example, based on a ratio between the time width of the first time frame and the time width of the second time frame.

For example, the time width of the first time frame is set to "60 minutes", and the time width of the second time frame is set to "30 minutes". In this case, the information processing device 101 calculates the second OD traffic volume q2 for each second time frame, by distributing (dividing into halves) the first OD traffic volume q1 for each first time frame at "1:1" for each second time frame.

For example, the first OD traffic volume q1 of the first time frame "6:00 to 7:00" is set to a "first OD traffic volume q1_1". Furthermore, the second OD traffic volume q2 of the second time frame "6:00 to 6:30" is set to a "second OD traffic volume q2_1". Furthermore, the second OD traffic volume q2 of the second time frame "6:30 to 7:00" is set to a "second OD traffic volume q2_2".

In this case, the first OD traffic volume q1_1 is distributed into the second time frame of "6:00 to 6:30" and the second time frame of "6:30 to 7:00" at "1:1", and the second OD traffic volumes q2_1 and q2_2 are calculated. The second OD traffic volume q2_1 is "q2_1 = q1_1 × 0.5". Furthermore, the second OD traffic volume q2_2 is "q2_2 = q1_0 × 0.5".

(4) The information processing device 101 performs a second simulation 120, using the calculated second OD traffic volume q2. Here, the second simulation 120 is a traffic simulation for estimating a traffic volume for each link included in the path from the first point to the second point, for each second time frame obtained by dividing the first time frame.

(5) The information processing device 101 repeatedly performs the second simulation 120 while adjusting the second OD traffic volume q2, so as to reduce the error between the estimated traffic volume of the link and the observed traffic volume for the link. As a result, the information processing device 101 determines the OD traffic volume for each second time frame, for a pair of the first point and the second point.

Specifically, for example, the information processing device 101 calculates the error between the estimated traffic volume of the link and the observed traffic volume for the link. In a case where the calculated error is larger than a threshold, the information processing device 101 updates the second OD traffic volume q2 based on the calculated error.

Then, the information processing device 101 performs the second simulation 120, using the updated second OD traffic volume q2. On the other hand, in a case where the calculated error is equal to or less than the threshold, the information processing device 101 determines the second OD traffic volume q2 used for the immediately preceding second simulation 120 as the OD traffic volume for each second time frame. The determined OD traffic volume for each second time frame is output, for example, as an OD estimation result.

In this way, according to the information processing device 101, it is possible to estimate the OD traffic volume in the fine time frame (second time frame), using the OD traffic volume estimated in the coarse time frame (first time frame). As a result, when estimating the OD traffic volume in the fine time frame, the information processing device 101 can reduce the number of repetitions until an optimal solution is obtained and shorten a processing time.

(System Configuration Example of Information Processing System 200)

Next, a system configuration example of an information processing system 200 according to the embodiment will be described. In the following description, a case will be described where the information processing device 101 illustrated in FIG. 1 is applied to the OD estimation device 201 in the information processing system 200.

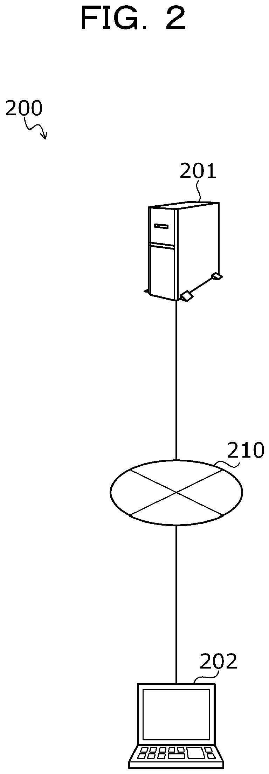

FIG. 2 is an explanatory diagram illustrating a system configuration example of the information processing system 200. In FIG. 2, the information processing system 200 includes the OD estimation device 201 and a client device 202. In the information processing system 200, the OD estimation device 201 and the client device 202 are coupled via a wired or wireless network 210. For example, the network 210 is the Internet, a local area network (LAN), a wide area network (WAN), or the like.

The OD estimation device 201 is, for example, a server. The client device 202 is a computer used by a user of the information processing system 200. The user is, for example, a person who considers traffic measures and evaluates the traffic measures. The client device 202 is, for example, a personal computer (PC), a tablet PC, or the like.

Note that, here, although the OD estimation device 201 and the client device 202 are separately provided, the embodiment is not limited to this. For example, the OD estimation device 201 may be implemented by the client device 202. Furthermore, the plurality of client devices 202 may be included in the information processing system 200.

(Hardware Configuration Example of OD Estimation Device 201)

Next, a hardware configuration example of the OD estimation device 201 will be described.

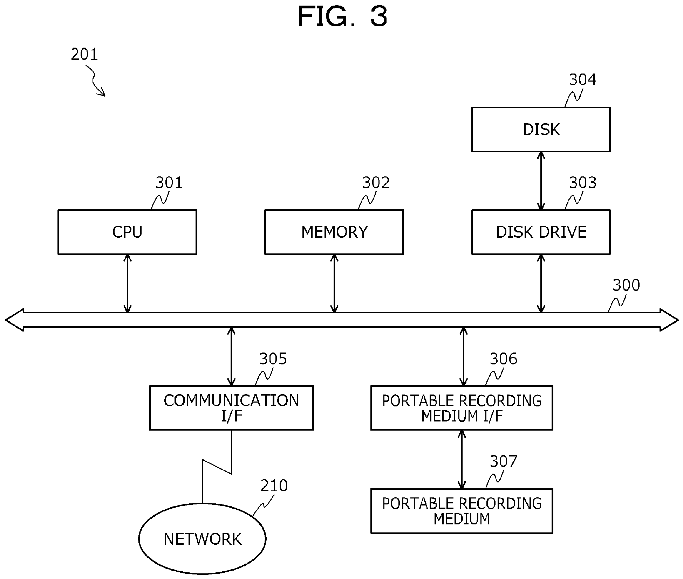

FIG. 3 is a block diagram illustrating a hardware configuration example of the OD estimation device 201. In FIG. 3, the OD estimation device 201 includes a central processing unit (CPU) 301, a memory 302, a disk drive 303, a disk 304, a communication interface (I/F) 305, a portable recording medium I/F 306, and a portable recording medium 307. Furthermore, each component is coupled to each other by a bus 300.

Here, the CPU 301 performs overall control of the OD estimation device 201. The CPU 301 may include a plurality of cores. The memory 302 includes, for example, a read only memory (ROM), a random access memory (RAM), a flash ROM, or the like. Specifically, for example, the flash ROM stores an operating system (OS) program, the ROM stores application programs, and the RAM is used as a work area for the CPU 301. The programs stored in the memory 302 are loaded into the CPU 301 to cause the CPU 301 to execute coded processes.

The disk drive 303 controls reading/writing of data from/to the disk 304 under the control of the CPU 301. The disk 304 stores data written under the control of the disk drive 303. For example, the disk 304 is a magnetic disk, an optical disk, or the like.

The communication I/F 305 is coupled to the network 210 through a communication line and is coupled to an external computer (for example, the client device 202 illustrated in FIG. 2) via the network 210. Then, the communication I/F 305 controls an interface between the network 210 and the inside of the device and controls input/output of data to/from the external computer. The communication I/F 305 is, for example, a modem, a LAN adapter, or the like.

The portable recording medium I/F 306 controls reading/writing of data from/to the portable recording medium 307 under the control of the CPU 301. The portable recording medium 307 stores data written under the control of the portable recording medium I/F 306. The portable recording medium 307 is, for example, a compact disc (CD)-ROM, a digital versatile disk (DVD), a universal serial bus (USB) memory, or the like.

Note that the OD estimation device 201 may include, for example, an input device, a display, or the like, in addition to the components described above. Furthermore, the client device 202 illustrated in FIG. 2 can be implemented by the hardware configuration similar to the OD estimation device 201. However, for example, the client device 202 includes an input device, a display, or the like, in addition to the components described above.

(Specific Example of Road Network)

Next, the road network will be described. The road network corresponds to a road of which a traffic demand is estimated.

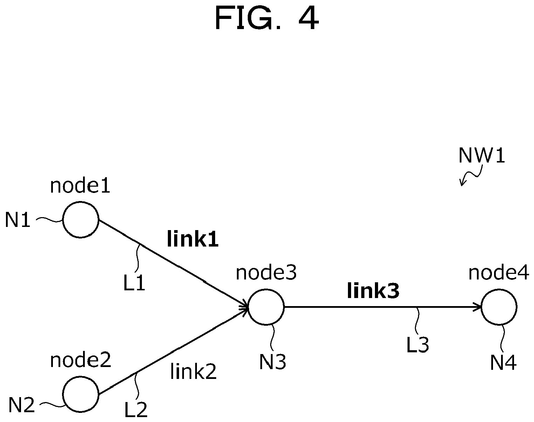

FIG. 4 is an explanatory diagram illustrating a specific example of the road network. In FIG. 4, a road network NW1 includes nodes N1 to N4 and links L1 to L3. Each of the nodes N1 to N4 represents an intersection. Each of the links L1 to L3 represents a road between the intersections.

In FIG. 4, node1 is a name (node name) of the node N1. Node2 is a name of the node N2. Node3 is a name of the node N3. Node4 is a name of the node N4. Link1 is a name (link name) of the link L1. Link2 is a name of the link L2. Link3 is a name of the link L3.

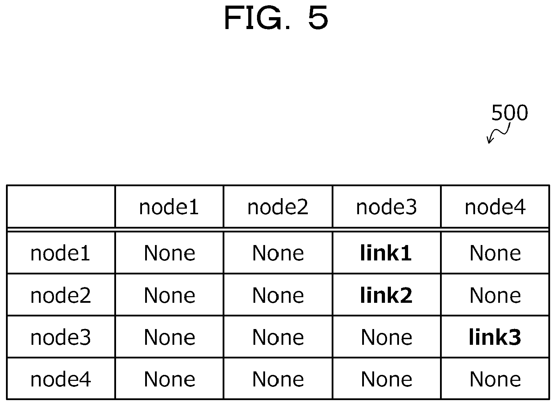

The road network NW1 is expressed, for example, by a road network table 500 illustrated in FIG. 5.

FIG. 5 is an explanatory diagram illustrating a specific example of the road network table. In FIG. 5, the road network table 500 indicates a network structure of the road network NW1 illustrated in FIG. 4. In the road network table 500, the name of the link that couples between the nodes is indicated for each combination of two nodes included in the road network NW1. However, "None" is set between nodes having no coupling relationship.

For example, the link1 is indicated for a combination of the node1 and the node3, and it can be specified that the link L1 couples between the nodes N1 and N3. Furthermore, None is indicated for a combination of the node1 and the node2, and it can be specified that the nodes N1 and N2 are not coupled.

(Specific Example of Origin Table)

Next, a specific example of an origin table used by the OD estimation device 201 will be described.

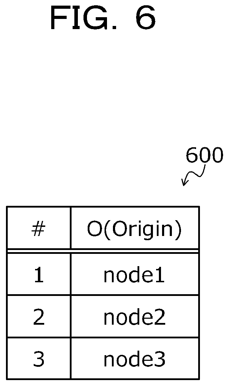

FIG. 6 is an explanatory diagram illustrating a specific example of the origin table. In FIG. 6, an origin table 600 indicates names of nodes "node1, node2, and node3" to be origins (O), in the road network NW1. The origin (O) represents an origin. A reference # in FIG. 6 is an identifier used to identify the origin (O).

(Specific Example of Destination Table)

Next, a specific example of a destination table used by the OD estimation device 201 will be described.

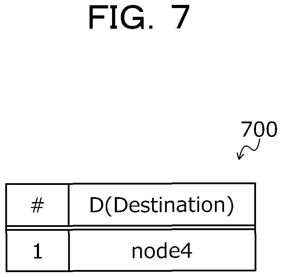

FIG. 7 is an explanatory diagram illustrating a specific example of the destination table. In FIG. 7, a destination table 700 indicates a name of a node (node4) to be a destination (D), in the road network NW1. The destination (D) represents a destination. A reference # in FIG. 7 is an identifier used to identify the destination (D).

(Specific Example of OD Pair Table)

Next, a specific example of an OD pair table used by the OD estimation device 201 will be described.

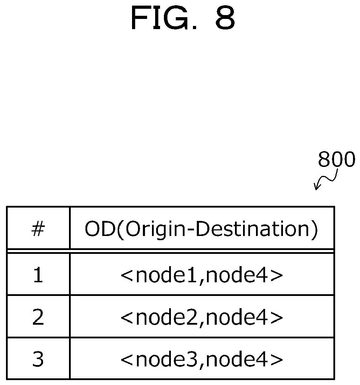

FIG. 8 is an explanatory diagram illustrating a specific example of the OD pair table. In FIG. 8, an OD pair table 800 indicates an OD pair in the road network NW1. The OD pair is a combination of an origin (O) and a destination (D). A reference # in FIG. 8 is an identifier used to identify the OD pair.

The OD pair is specified from the origin table 600 illustrated in FIG. 6 and the destination table 700 illustrated in FIG. 7, for example. For example, an OD pair 1 is a combination of O: the node N1 (node1) and D: the node N4 (node4).

(Specific Example of Path Table)

Next, a specific example of a path table used by the OD estimation device 201 will be described.

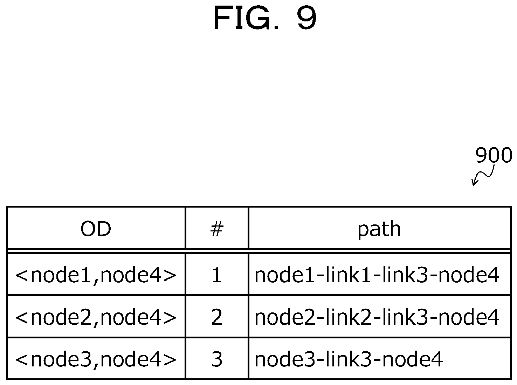

FIG. 9 is an explanatory diagram illustrating a specific example of the path table. In FIG. 9, a path table 900 indicates a path (path) corresponding to the OD pair in the road network NW1. The path (path) is a path from an origin (O) to a destination (D). A reference # in FIG. 9 is an identifier used to identify the path (path).

For example, path1 is a path "node1-link1-link3-node4" from O: the node N1 (node1) to D: the node N4 (node4). Note that, in the path, display of a node (for example, node3) to be a via-point is omitted.

(Functional Configuration Example of OD Estimation Device 201)

Next, a functional configuration example of the OD estimation device 201 will be described.

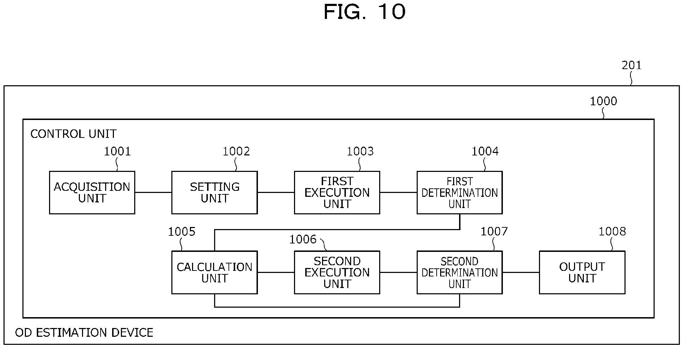

FIG. 10 is a block diagram illustrating a functional configuration example of the OD estimation device 201. In FIG. 10, the OD estimation device 201 includes an acquisition unit 1001, a setting unit 1002, a first execution unit 1003, a first determination unit 1004, a calculation unit 1005, a second execution unit 1006, a second determination unit 1007, and an output unit 1008. The acquisition unit 1001 to the output unit 1008 are functions to be a control unit 1000, and specifically, for example, the functions are implemented by causing the CPU 301 to execute programs stored in a storage device such as the memory 302, the disk 304, or the portable recording medium 307 illustrated in FIG. 3 or by the communication I/F 305. A processing result of each functional unit is stored, for example, in a storage device such as the memory 302 or the disk 304.

The acquisition unit 1001 acquires the road network table. Here, the road network table is information representing a road of which a traffic demand is estimated (for example, road network NW1 illustrated in FIG. 4). Specifically, for example, the acquisition unit 1001 acquires the road network table 500 illustrated in FIG. 5, by receiving the road network table 500 from the client device 202 illustrated in FIG. 2. Furthermore, the acquisition unit 1001 may acquire the road network table 500, by an operation input by the user using an input device (not illustrated).

Furthermore, the acquisition unit 1001 acquires the origin table and the destination table. Here, the origin table is information representing the origins, and represents, for example, a node to be the origin (O) in the road network. The destination table is information representing the destinations, and represents, for example, a node to be the destination (D) in the road network.

Specifically, for example, the acquisition unit 1001 acquires the origin table 600 illustrated in FIG. 6 and the destination table 700 illustrated in FIG. 7, by receiving the tables from the client device 202. Furthermore, the acquisition unit 1001 may acquire the origin table 600 and the destination table 700, by the operation input by the user using the input device (not illustrated).

Furthermore, the acquisition unit 1001 acquires the OD pair table. Here, the OD pair table is information representing a combination (OD pair) of an origin (O) and a destination (D). Specifically, for example, the acquisition unit 1001 acquires the OD pair table 800 illustrated in FIG. 8 by creating the OD pair table 800 from the origin table 600 and the destination table 700.

Furthermore, the acquisition unit 1001 may acquire the OD pair table 800, for example, by receiving the OD pair table 800 from the client device 202. Furthermore, the acquisition unit 1001 may acquire the OD pair table 800, by the operation input by the user using the input device (not illustrated).

Furthermore, the acquisition unit 1001 acquires the path table. Here, the path table is information indicating the path (path) from the origin (O) to the destination (D), corresponding to the OD pair in the road network. Specifically, for example, the acquisition unit 1001 acquires the path table 900 illustrated in FIG. 9, by creating the path table 900 from the road network table 500 and the OD pair table 800.

Furthermore, the acquisition unit 1001 may acquire the path table 900, for example, by receiving the path table 900 from the client device 202. Furthermore, the acquisition unit 1001 may acquire the path table 900, by the operation input by the user using the input device (not illustrated).

Furthermore, the acquisition unit 1001 acquires a path selection table. Here, the path selection table is information indicating a probability (path selection probability) that a path (path) corresponding to the OD pair in the road network is selected. Specifically, for example, the acquisition unit 1001 acquires the path selection table by receiving the path selection table from the client device 202. Furthermore, the acquisition unit 1001 may acquire the path selection table, by the operation input by the user using the input device (not illustrated).

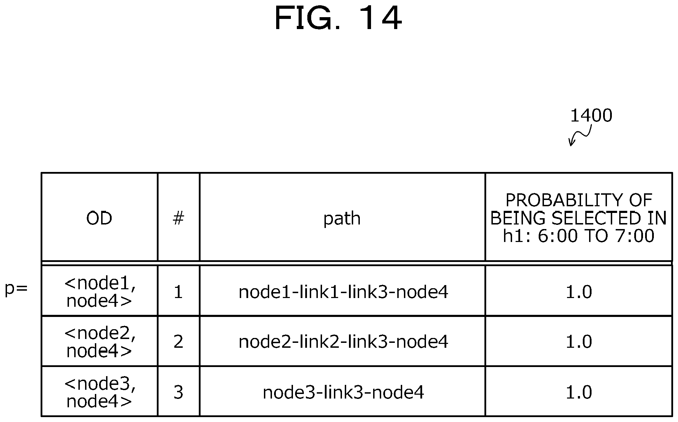

Note that a specific example of the path selection table will be described later, for example, with reference to FIG. 14.

Furthermore, the acquisition unit 1001 acquires link flow observation data. Here, the link flow observation data is information indicating a traffic volume that is actually observed for the link in the road network. The traffic volume is represented, for example, by the number of vehicles that have passed through the link. The traffic volume is observed using, for example, a sensor (for example, vehicle counter) that is provided on a road and detects a vehicle traveling on the road.

However, it is difficult to provide the sensors for all the links in the road network. Therefore, the sensor is provided on at least some links in the road network, and the number of vehicles that have passed through the link or the like is observed.

Specifically, for example, the acquisition unit 1001 acquires the link flow observation data, by receiving the link flow observation data from the client device 202. Furthermore, the acquisition unit 1001 may acquire the link flow observation data, by the operation input by the user using the input device (not illustrated). Furthermore, the acquisition unit 1001 may acquire the link flow observation data from a data providing service (not illustrated).

The setting unit 1002 sets an initial OD flow, when performing a first traffic simulation. Here, the traffic simulation (for example, first traffic simulation) is to reproduce a traffic phenomenon occurring on a road with a computer and simulate how a traffic situation changes. The traffic simulation is performed, for example, using a traffic simulator.

The initial OD flow is an OD flow given to the traffic simulation as an initial value. The OD flow is information representing a traffic volume for departing the origin (first point) and reaching the destination (second point) in the time frame, for each time frame and corresponds to the OD traffic volume.

In the traffic simulation, the traffic volume for each link included in the path from the origin to the destination is estimated, using the OD flow. The traffic volume is represented, for example, by the number of vehicles. The initial OD flow may be, for example, a predetermined constant or may be represented by a randomly generated random number.

Specifically, for example, the setting unit 1002 creates the OD flow representing the number of vehicles for departing the origin and reaching the destination in the first time frame for each first time frame obtained by dividing the target period, by the constant or the random number. Then, the setting unit 1002 sets the created OD flow as the initial OD flow.

Here, the target period is a period that is arbitrarily set in advance and may be any time period in a day or may be a period of two or more days, for example. The first time frame is a period that is arbitrarily set in advance, and a time frame (longer time width) coarser than the time frame of the OD flow to be finally estimated is set. The combination (OD pair) of the origin (first point) and the destination (second point) is specified, for example, from the OD pair table 800.

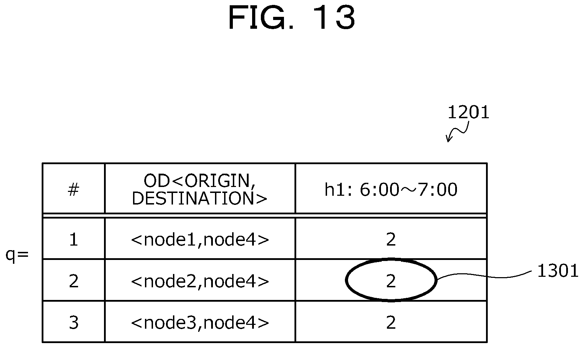

Note that a specific example of the initial OD flow will be described later with reference to FIG. 13, for example.

The first execution unit 1003 sets the set initial OD flow as a first OD flow. The first OD flow corresponds to the first OD traffic volume. Then, the first execution unit 1003 performs the first traffic simulation using the first OD flow. The first traffic simulation is a traffic simulation for estimating the traffic volume for each link included in the path from the origin (first point) to the destination (second point), for each first time frame obtained by dividing the target period.

Specifically, for example, the first execution unit 1003 performs the first traffic simulation, by giving the road network table (road network), the initial OD flow, the path table, and the path selection table to the traffic simulator. As the traffic simulator, for example, any existing simulator may be used.

As a result, a link flow is obtained. The link flow is information representing the estimated traffic volume of the link. For example, the link flow represents the traffic volume for each link included in the path from the origin (first point) to the destination (second point), for each first time frame obtained by dividing the target period.

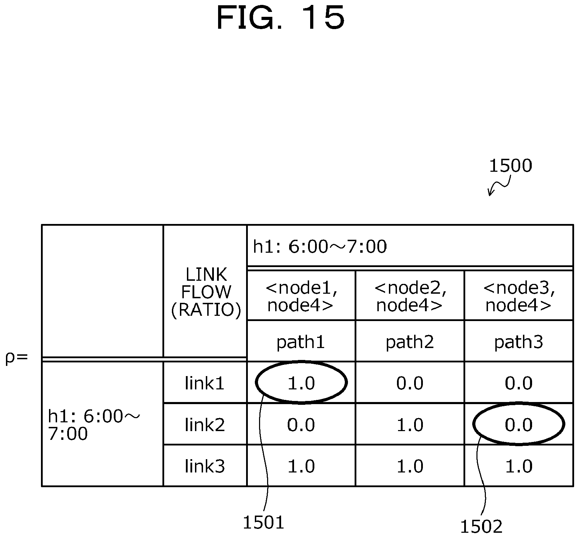

Note that a specific example of the link flow will be described later with reference to FIG. 15, for example.

The first determination unit 1004 repeatedly performs the first traffic simulation while adjusting the first OD flow, so as to reduce the error between the estimated traffic volume of the link and the observed traffic volume for the link. As a result, the first determination unit 1004 determines the OD flow for each first time frame, for the OD pair. The OD pair is the combination of the origin (first point) and the destination (second point). The observed traffic volume for the link is specified from the link flow observation data.

Specifically, for example, the first determination unit 1004 calculates the error between the estimated traffic volume of the link (link flow) and the observed traffic volume for the link. However, there is a case where the sensor (for example, vehicle counter) is provided only for some of the links in the road network and the traffic volume only for the links is observed.

In this case, the first determination unit 1004 extracts a link where the traffic volume (for example, the number of vehicles) can be observed from the road network. To extract the link, for example, an observation matrix is used. The observation matrix is a matrix used to extract a link where a traffic volume can be observed in the target period, from among the links in the road network.

Next, the first determination unit 1004 extracts a link flow of the extracted link, from among the estimated link flows of the respective links, for each first time frame. Then, the first determination unit 1004 calculates an error between the link flow (estimated link flow) of the extracted link and a link flow observed for the link (actually measured link flow), for each first time frame.

Next, the first determination unit 1004 determines whether or not the calculated error is within an allowable range. More specifically, for example, the first determination unit 1004 calculates a sum of the errors by adding the error calculated for each link. Then, in a case where the sum of the calculated errors is equal to or less than a threshold a, the first determination unit 1004 determines that the error is within the allowable range. On the other hand, in a case where the sum of the errors is larger than the threshold o, the first determination unit 1004 determines that the error is not within the allowable range. The threshold $\alpha$ can be arbitrarily set.

Furthermore, in a case where a variation amount of the sum of the calculated errors is equal to or less than a threshold $\beta$, the first determination unit 1004 may determine that the error is within the allowable range. The variation amount of the sum of the errors is specified by a ratio of a sum of errors at this time, with respect to a sum of errors at the previous time, in a case where the first traffic simulation is repeatedly performed. On the other hand, in a case where the variation amount of the sum of the errors is larger than the threshold β, the first determination unit 1004 determines that the error is not within the allowable range. The threshold β can be arbitrarily set and set to a value of about 10%, for example.

Note that, here, a case where the sum of the errors is calculated has been described as an example. However, the embodiment is not limited to this. For example, in a case where each calculated error of each link is equal to or less than a threshold γ, the first determination unit 1004 may determine that the error is within the allowable range. On the other hand, in a case where at least any one of the calculated errors of the respective links is larger than the threshold γ, the first determination unit 1004 may determine that the error is not within the allowable range. The threshold γ can be arbitrarily set.

Here, in a case where the calculated error is not within the allowable range, the first determination unit 1004 updates the first OD flow based on the calculated error. More specifically, for example, the first determination unit 1004 calculates a correction value of the first OD flow, based on the calculated error. Next, the first determination unit 1004 updates the first OD flow, using the calculated correction value.

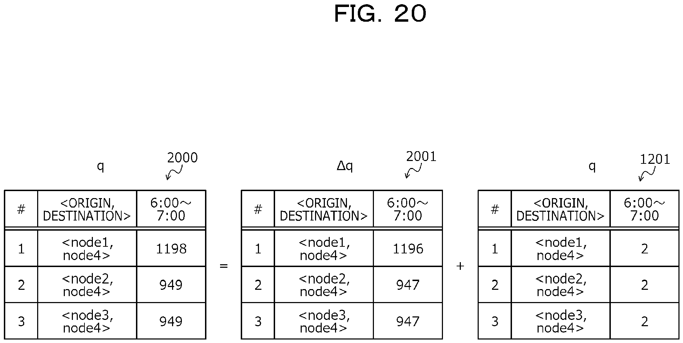

Note that an update example of the first OD flow will be described later with reference to FIG. 20.

Then, the first determination unit 1004 performs the first traffic simulation, using the updated first OD flow. Furthermore, in a case where the calculated error is within the allowable range, the first determination unit 1004 determines the first OD flow used for the immediately preceding first traffic simulation as the OD flow for each first time frame.

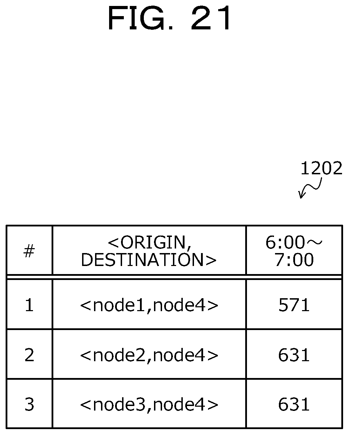

A specific example of the determined OD flow for each first time frame will be described later with reference to FIG. 21.

The calculation unit 1005 calculates a second OD flow for departing the origin (first point) and reaching the destination (second point) in the second time frame, for each second time frame obtained by dividing the first time frame, based on the determined OD flow for each first time frame. The second time frame is, for example, a time frame obtained by dividing the first time frame into two.

Specifically, for example, the calculation unit 1005 calculates the second OD flow, by distributing the determined OD flow for each first time frame, for each second time frame according to a predetermined ratio. The predetermined ratio may be set, for example, based on the ratio between the time width of the first time frame and the time width of the second time frame.

Furthermore, the predetermined ratio may be set, for example, based on a ratio of a traffic volume for each second time frame observed for a first link included in the path from the origin (first point) to the destination (second point). For example, the first link is a link coupled to a node of the origin (first point), for example.

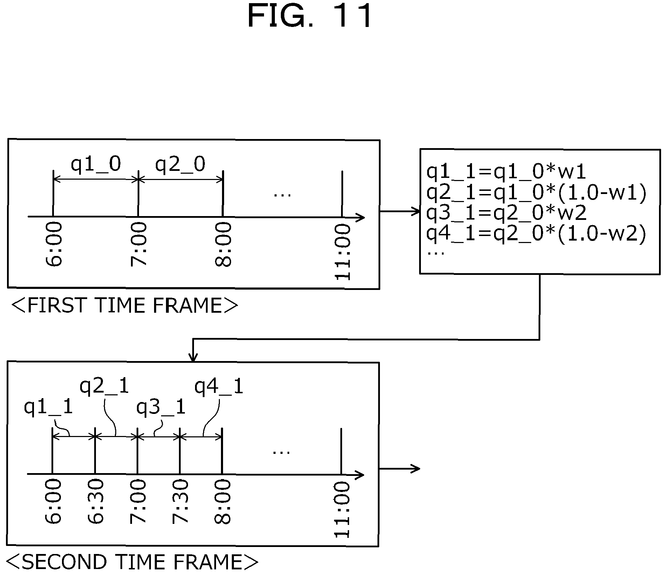

Note that a calculation example of the second OD flow will be described later with reference to FIG. 11.

The second execution unit 1006 performs a second traffic simulation using the calculated second OD flow. The second traffic simulation is a traffic simulation for estimating the traffic volume for each link included in the path from the origin (first point) to the destination (second point), for each second time frame obtained by dividing the first time frame.

Specifically, for example, the second execution unit 1006 performs the second traffic simulation, by giving the road network table (road network), the second OD flow, the path table, and the path selection table to the traffic simulator. As a result, the link flow representing the traffic volume for each link included in the path from the origin (first point) to the destination (second point) is obtained for each second time frame.

The second determination unit 1007 repeatedly performs the second traffic simulation while adjusting the second OD flow, so as to reduce the error between the estimated traffic volume of the link and the observed traffic volume for the link. As a result, the first determination unit 1004 determines the OD flow for each second time frame, for the OD pair.

Specifically, for example, the second determination unit 1007 calculates the error between the estimated traffic volume of the link (link flow) and the observed traffic volume for the link. More specifically, for example, the second determination unit 1007 extracts a link where the traffic volume can be observed from the road network, using the observation matrix.

Next, the second determination unit 1007 extracts a link flow of the extracted link, from among the estimated link flows of the respective links, for each second time frame. Then, the second determination unit 1007 calculates an error between the extracted link flow (estimated link flow) of the link and a link flow observed for the link (actually measured link flow), for each second time frame.

Next, the second determination unit 1007 determines whether or not the calculated error is within the allowable range. Here, in a case where the calculated error is not within the allowable range, the second determination unit 1007 updates the second OD flow based on the calculated error. More specifically, for example, the second determination unit 1007 calculates a correction value of the second OD flow, based on the estimated link flow of the link and the calculated error. Next, the second determination unit 1007 updates the second OD flow using the calculated correction value.

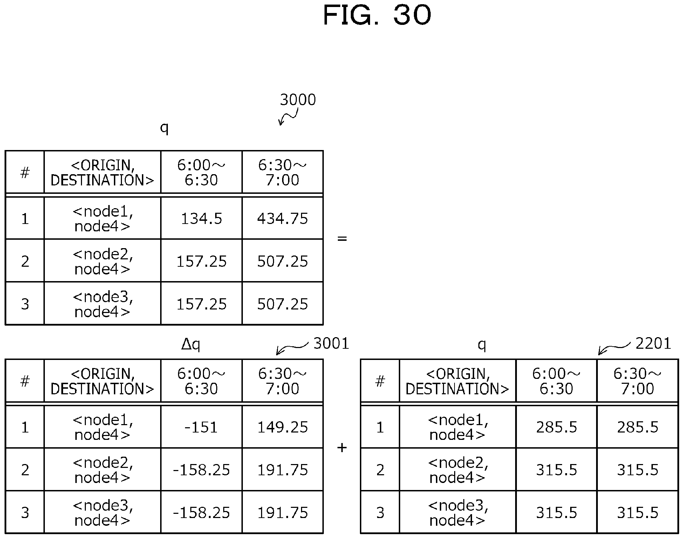

Note that an update example of the second OD flow will be described later with reference to FIG. 30.

Then, the second determination unit 1007 performs the second traffic simulation, using the updated second OD flow. Furthermore, in a case where the calculated error is within the allowable range, the second determination unit 1007 determines the second OD flow used for the immediately preceding second traffic simulation as the OD flow for each second time frame.

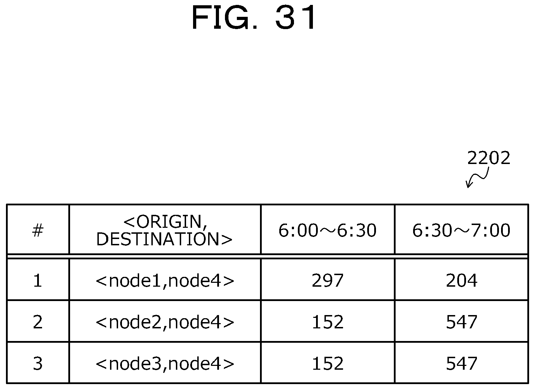

A specific example of the determined OD flow for each second time frame will be described later with reference to FIG. 31.

The output unit 1008 outputs the determined OD flow for each second time frame, in association with the OD pair. The OD pair is the combination of the origin (first point) and the destination (second point). An output format of the output unit 1008 includes, for example, storage in a storage device such as the memory 302 or the disk 304, transmission to another computer by the communication I/F 305, display on a display (not illustrated), print output to a printer (not illustrated), and the like.

Specifically, for example, the output unit 1008 transmits an OD flow 2202 (OD estimation result) illustrated in FIG. 31 to the client device 202. As a result, in the client device 202, the user can refer to the OD flow (for example, the number of vehicles) for each second time frame, for the OD pair (origin and destination).

Note that there is a case where it is desired to estimate an OD flow with a time width finer than the second time frame. Therefore, the second determination unit 1007 may determine whether or not the second time frame is a time frame designated in advance. The designation of the time frame is received, for example, from the client device 202.

For example, it is assumed that the second time frame be a time frame at 30-minute intervals. Furthermore, it is assumed that the designated time frame be a time frame at 15-minute intervals. In this case, the second determination unit 1007 determines that the second time frame is not the designated time frame. In a case where it is determined that the second time frame is not the designated time frame, the calculation unit 1005 sets the determined OD flow for each second time frame as the OD flow for each first time frame.

Then, the calculation unit 1005 may calculate the second OD flow, for each second time frame obtained by dividing the first time frame. As a result, for example, the OD estimation device 201 can estimate the OD flow for each designated time frame, by repeating the estimation of the OD flow, while gradually fining the time frame.

(Calculation Example of Second OD Flow)

Next, the calculation example of the second OD flow will be described with reference to FIG. 11.

FIG. 11 is an explanatory diagram illustrating the calculation example of the second OD flow. In FIG. 11, the target period is set to "6:00 to 11:00". Furthermore, the time width of the first time frame is set to "60 minutes", and the time width of the second time frame is set to "30 minutes".

In this case, the first time frame is, for example, "6:00 to 7:00", "7:00 to 8:00", or the like. Furthermore, when the first time frame is set to "6:00 to 7:00", the second time frames are "6:00 to 6:30" and "6:30 to 7:00". Furthermore, when the first time frame is set to "7:00 to 8:00", the second time frames are "7:00 to 7:30" and "7:30 to 8:00".

Here, the first OD flow of "6:00 to 7:00" of a certain OD pair is set to "q1_0", and the first OD flow of "7:00 to 8:00" is set to "q2_0". In this case, when the second OD flow of "6:00 to 6:30" of the same OD pair is set to °q1_1", q1_1 is calculated using the following formula (1). Furthermore, when the second OD flow of "6:30 to 7:00" of the same OD pair is set to °q2_1", q2_1 is calculated using the following formula (2).

Furthermore, when the second OD flow of "7:00 to 7:30" of the same OD pair is set to "q3_1", q3_1 is calculated using the following formula (3). Furthermore, when the second OD flow of "7:30 to 8:00" of the same OD pair is set to "q4_1", q4_1 is calculated using the following formula (4). However, w1 is a constant larger than zero and less than one. The reference w2 is a weight (constant) larger than zero and less than one.

$$q1\_1 = q1\_0 * w1 \ ... \ (1)$$

$$q2\_1 = q1\_0 * (1.0 - w1) \ ... \ (2)$$

$$q3\_1 = q2\_0 * w2 \ ... \ (3)$$

$$q4\_1 = q2\_0 * (1.0 - w2) \ ... \ (4)$$

The weights w1 and w2 are set, for example, based on the time widths of the first time frame and the second time frame. In the example in FIG. 11, the ratio of the time widths of the first time frame and the second time frame is "2:1". In this case, the weight w1 is °w1 = 1 = 2 = 0.5". Similarly, the weight w2 is "w2 = 1 ÷ 2 = 0.5".

Furthermore, the weights w1 and w2 may be set, for example, based on a ratio of a traffic volume for each second time frame observed for a link included in the path from the origin (first point) to the destination (second point).

Here, the origin is set to the node1 in the road network NW1, and the destination is set to the node4 in the road network NW1 (refer to FIG. 4). A path from the node1 (O) to the node4 (D) is "node1-link1-link3-node4".

For example, it is assumed that the first OD flow q1_0 in the first time frame "6:00 to 7:00" be "q1_0 = 10 vehicles". Furthermore, it is assumed that a traffic volume (link flow) in the second time frame "6:00 to 6:30" observed by the sensor (vehicle counter) provided at the link1 be "two vehicles" and a traffic volume in the second time frame "6:30 to 7:00" be "eight vehicles".

The weight w1 in the second time frame "6:00 to 6:30" is, for example, "w1 = 2/10 = 0.2". In this case, the second OD flow q1_1 in the second time frame "6:00 to 6:30" is "10 × 0.2 = 2 vehicles" from the above formula (1). Furthermore, the second OD flow q2_1 in the second time frame "6:30 to 7:00" is "10 × (1 - 0.2) = 8 vehicles" from the above formula (2).

(Estimation Example of OD Flow)

Next, an estimation example of the OD flow by the OD estimation device 201 will be described. Here, a case will be described where the OD flow in the fine time frame (second time frame) corresponding to each OD pair in the road network NW1 illustrated in FIG. 4 is estimated, based on the road network table 500, the origin table 600, the destination table 700, the OD pair table 800, and the path table 900 illustrated in FIGs. 5 to 9.

· OD flow estimation in coarse time frame

The OD estimation device 201 estimates the OD flow in the coarse time frame (first time frame) by the first traffic simulation. Here, the coarse time frame (first time frame) is set to a time frame for each 60 minutes. Furthermore, for convenience, a case will be described as an example where the target period is set to "h1: 6:00 to 7:00" and only one time frame (first time frame) is included in the target period. Furthermore, the time frame °h1: 6:00 to 7:00" may be simply referred to as a time frame h1.

Hereinafter, specific processing content when the OD flow in the coarse time frame (first time frame) is estimated will be described.

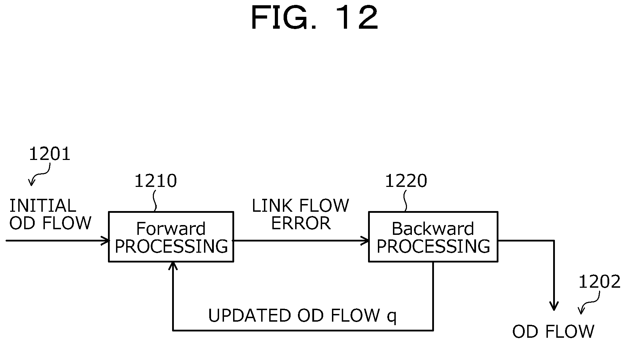

FIG. 12 is an explanatory diagram illustrating a first operation example of the OD estimation device 201. In FIG. 12, an operation repeatedly performed by the OD estimation device 201 when the OD flow in the coarse time frame (first time frame) is estimated is illustrated.

First, the OD estimation device 201 sets an initial OD flow 1201, as preliminary preparation. The initial OD flow 1201 is an OD flow to be given to the first traffic simulation as an initial value, and indicates an OD flow (for example, random number or constant) for each 60 minutes corresponding to each OD pair.

FIG. 13 is an explanatory diagram illustrating a specific example of the initial OD flow. In FIG. 13, the initial OD flow 1201 indicates an OD flow in the time frame h1 corresponding to each of the OD pairs 1 to 3. Each OD flow indicates the number of vehicles. For example, "2" indicated by a reference numeral 1301 indicates the number of vehicles (OD flow) that depart the node2 and reach the node4 in the time frame h1.

Next, the OD estimation device 201 sets the initial OD flow 1201 to an OD flow q (first OD flow) in Forward processing 1210 (refer to FIG. 12). Then, the OD estimation device 201 performs the first traffic simulation, using the OD flow q.

Specifically, for example, the OD estimation device 201 performs the first traffic simulation, by giving the road network table 500, the OD flow q (initial OD flow 1201), the path table 900, the OD pair table 800, and the path selection table (refer to FIG. 14) to the traffic simulator.

Here, a specific example of the path selection table will be described with reference to FIG. 14.

FIG. 14 is an explanatory diagram (part 1) illustrating the specific example of the path selection table. In FIG. 14, a path selection table 1400 indicates a probability (path selection probability) that a path (path) corresponding to each OD pair in the road network NW1 is selected in the time frame h1: 6:00 to 7:00. The reference # in FIG. 14 is an identifier used to identify a path (path).

For example, a probability that the path1 (node1-link1-link3-node4) corresponding to an OD <node1, node4> is "1.0". The path selection probability of each path depends on a time period. For example, even the same path is used, there is a case where a path selection probability from 6:00 to 6:59 and a path selection probability from 12:00 to 12:59 are different.

In the example in FIG. 14, there is only one path corresponding to each OD pair. Therefore, for each OD pair, there is no other path that can be selected when moving from O to D, and the path selection probability of each path is "1.0". However, there is a case where the plurality of paths (path) exists for the same OD pair. In this case, a sum of the path selection probabilities of the plurality of paths is °1.0".

In the first traffic simulation, for example, a virtual vehicle is caused to depart from the origin every five minutes during "6:00 to 7:00" and is caused to travel toward the destination. However, it is assumed that the vehicles that have departed within the same time frame reach the destination within the same time frame. For example, all the vehicles that have departed the node1 (origin) between "6:00 to 7:00" reach the node4 (destination) before "7:00". It is assumed that no congestion occur.

When the first traffic simulation is completed, a link flow (traffic volume) estimation result for each link included in the path (path) corresponding to each OD pair in the time frame h1 is obtained. The link flow is, for example, the number of vehicles that have passed through the link.

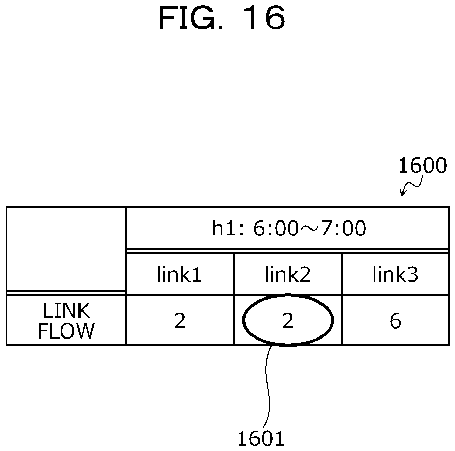

Here, a specific example of the link flow estimated by the first traffic simulation will be described with reference to FIGs. 15 and 16.

FIG. 15 is an explanatory diagram (part 1) illustrating the specific example of the link flow (ratio). In FIG. 15, a link flow 1500 is information ($\rho$) obtained by the first traffic simulation and represents a link flow (ratio) for each link included in the path (path) corresponding to each OD pair in the time frame h1: 6:00 to 7:00.

The link flow (ratio) indicates a ratio of vehicles that have passed through each link in the time frame h1, among the vehicles that have passed through the path (path) corresponding to each OD pair and travel from the origin to the destination. The link flow (ratio) is a value according to the path selection probability of the path (path) corresponding to each OD pair in the path selection table 1400 illustrated in FIG. 14, for example.

For example, "1.0" indicated by a reference numeral 1501 indicates a ratio of vehicles that pass through the link1, among the vehicles that pass through the path1 and travel from the node1 to the node4 in the time frame h1. Furthermore, "0.0" indicated by a reference numeral 1502 indicates a ratio of vehicles that pass through the link2, among the vehicles that pass through the path3 and travel from the node3 to the node4 in the time frame h1.

The OD estimation device 201 calculates the link flow (traffic volume) based on the link flow 1500, for example, using the following formula (5). However, the reference numeral x indicates a link flow (traffic volume). The reference numeral $\rho$ indicates a link flow (ratio). The reference numeral p indicates a path selection probability. The reference q indicates an OD flow.

$$x = \rho p q \ \dots (5)$$

Here, when it is assumed that $\rho$ be the link flow 1500 illustrated in FIG. 15, x is calculated as in the following formula (6) and is a link flow 1600 illustrated in FIG. 16.
[Expression 1]

$$x = \rho p q = \begin{bmatrix} 1.0 & 0.0 & 0.0 \\ 0.0 & 1.0 & 0.0 \\ 1.0 & 1.0 & 1.0 \end{bmatrix} \begin{bmatrix} 1.0 & 0.0 & 0.0 \\ 0.0 & 1.0 & 0.0 \\ 0.0 & 0.0 & 1.0 \end{bmatrix} \begin{bmatrix} 2 \\ 2 \\ 2 \end{bmatrix} = \begin{bmatrix} 2 \\ 2 \\ 6 \end{bmatrix} \dots (6)$$

FIG. 16 is an explanatory diagram (part 1) illustrating a specific example of the link flow (traffic volume). In FIG. 16, the link flow 1600 is information (x) estimated by the first traffic simulation and represents the link flow (traffic volume) for each link included in the path (path) corresponding to each OD pair, in the time frame h1: 6:00 to 7:00.

The link flow (traffic volume) indicates the number of vehicles that have passed through each link in the time frame h1. For example, "2" indicated by a reference numeral 1601 indicates the number of vehicles that have passed through the link2 in the time frame h1. As a result, the OD estimation device 201 can estimate the traffic volumes (the number of vehicles) for all the links included in the path (path) corresponding to each OD pair.

Here, although all the traffic volumes of all the links can be calculated on the simulator, in a real world, it is difficult to provide the sensors (vehicle counter or the like) for all the links (road) on the road network. Therefore, the OD estimation device 201 extracts a traffic volume of a link where the traffic volume can be actually observed.

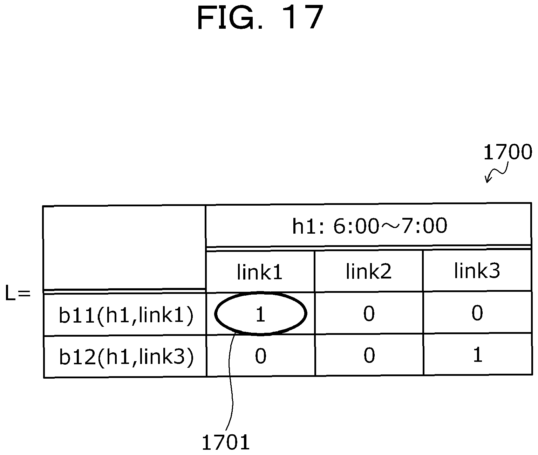

Here, it is assumed that the sensors (vehicle counter) be provided only for the link1 and the link3 in the road network NW1. Therefore, the OD estimation device 201 extracts the link where the traffic volume can be observed from the road network NW1, using an observation matrix 1700 illustrated in FIG. 17.

FIG. 17 is an explanatory diagram (part 1) illustrating an example of the observation matrix. In FIG. 17, the observation matrix 1700 is a matrix for extracting the link1 and the link3 where the traffic volume can be observed in the time frame h1, among the link1, the link2, and the link3 in the road network NW1. For example, "1" indicated by a reference numeral 1701 is a flag indicating that the traffic volume (the number of vehicles) that passes through the link1 in the time frame h1 can be observed.

Note that, in FIG. 17, the reference numeral b11 corresponds to information used to extract the link1 in the time frame h1. The reference numeral b12 corresponds to information used to extract the link3 in the time frame h1.

The OD estimation device 201 extracts the link flows (traffic volume) of the link1 and the link3 where the traffic volume can be observed in the time frame h1, among the link1, the link2, and the link3 in the road network NW1, for example, using the following formula (7). However, the reference numeral y indicates an observable link flow (traffic volume). The reference numeral L indicates an observation matrix. The reference numeral x indicates a link flow (traffic volume) calculated on the simulator.

$$y = Lx \ ... \ (7)$$

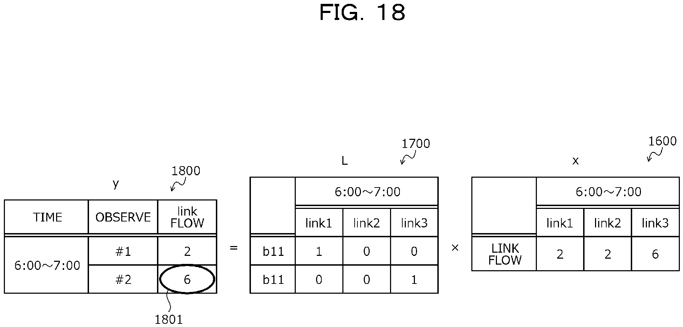

Here, when it is assumed that x be the link flow 1600 illustrated in FIG. 16 and L be the observation matrix 1700 illustrated in FIG. 17, y is calculated as in the following formula (8), and a link flow 1800 illustrated in FIG. 18 is extracted.
[Expression 2]

$$y = Lx = \begin{bmatrix} 1 & 0 & 0 \\ 0 & 0 & 1 \end{bmatrix} \begin{bmatrix} 2 \\ 2 \\ 6 \end{bmatrix} = \begin{bmatrix} 2 \\ 6 \end{bmatrix} \ ... \ (8)$$

FIG. 18 is an explanatory diagram (part 1) illustrating a specific example of the observable link flow (traffic volume). In FIG. 18, the link flow 1800 represents the link flows (traffic volume) of the link1 and the link3 actually observed in the time frame h1: 6:00 to 7:00. For example, "6" indicated by a reference numeral 1801 indicates the number of vehicles that have passed through the link2 in the time frame h1. The reference numeral # in FIG. 18 is an identifier used to identify the observed link flow (traffic volume).

Next, the OD estimation device 201 calculates an error between the link flow (traffic volume) calculated (estimated) on the simulator and the actually observed link flow (traffic volume), for example, using the following formula (9). However, $\Delta y$ indicates an error of the link flow (traffic volume). The reference numeral y' indicates an actually observed link flow (traffic volume). The reference numeral y indicates a link flow (traffic volume) calculated on the simulator.

$$\Delta y = y' - y \ ... \ (9)$$

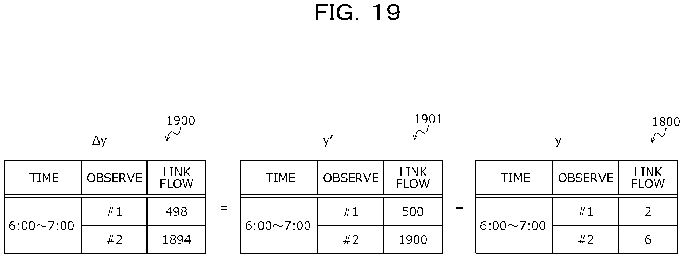

Here, when it is assumed that y be the link flow 1800 illustrated in FIG. 18, $\Delta y$ is calculated as illustrated in FIG. 19. The reference numeral y' is specified from the link flow observation data.

FIG. 19 is an explanatory diagram (part 1) illustrating a specific example of the error of the link flow (traffic volume). In FIG. 19, an error 1900 of the link flow (traffic volume) represents an error between the link flows (traffic volume) of the links 1 and 3 where the traffic volume can be observed, in the time frame h1: 6:00 to 7:00. Note that a link flow 1901 is a link flow (traffic volume) that is actually observed and is specified from the link flow observation data.

Here, a case is assumed where the calculated error 1900 of the link flow (traffic volume) is not within a predetermined allowable range.

In this case, the OD estimation device 201 updates the OD flow q, based on the error 1900 of the link flow (traffic volume), in Backward processing 1220 (refer to FIG. 12). The OD flow q before the update at this point is the initial OD flow 1201 illustrated in FIG. 13.

Specifically, for example, first, the OD estimation device 201 calculates the correction value of the OD flow q, using the following formula (10). Here, $\Delta q$ indicates a correction value of the OD flow q. The reference numeral w indicates a weight (constant). The reference numeral w is, for example, a value of zero to one. The reference numeral $p^T$ indicates a transposed matrix of p. The reference numeral $\rho^T$ indicates a transposed matrix of $\rho$. The reference numeral $L^T$ indicates a transposed matrix of L. The reference numeral $\Delta y$ indicates an error of the link flow (traffic volume).

$$\Delta q = wp^T\rho^TL^T\Delta y \ ... \ (10)$$

Here, w is set to "w = 0.5", p is set to the path selection table 1400 illustrated in FIG. 14, $\rho$ is set to the link flow 1500 illustrated in FIG. 15, L is set to the observation matrix 1700 illustrated in FIG. 17, and $\Delta y$ is set to the error 1900 of the link flow (traffic volume) illustrated in FIG. 19. In this case, $\Delta q$ is calculated as in the following formula (11).
[Expression 3]

$$\Delta q = w p^T \rho^T L^T \Delta y$$

$$= 0.5 \begin{bmatrix} 1.0 & 0.0 & 0.0 \\ 0.0 & 1.0 & 0.0 \\ 0.0 & 0.0 & 1.0 \end{bmatrix} \begin{bmatrix} 1.0 & 0.0 & 1.0 \\ 0.0 & 1.0 & 1.0 \\ 0.0 & 0.0 & 1.0 \end{bmatrix} \begin{bmatrix} 1.0 & 0.0 \\ 0.0 & 0.0 \\ 0.0 & 1.0 \end{bmatrix} \begin{bmatrix} 498 \\ 1894 \end{bmatrix} = \begin{bmatrix} 1196 \\ 947 \\ 947 \end{bmatrix} \quad ... (11)$$

Next, the OD estimation device 201 updates the OD flow q, for example, using the following formula (12).

$$q = \Delta q + q \quad ... (12)$$

Here, when Δq is set to a value calculated as in the above formula (11), the OD flow q is updated as illustrated in FIG. 20.

FIG. 20 is an explanatory diagram (part 1) illustrating an update example of the OD flow. In FIG. 20, an OD flow 2000 indicates an updated OD flow q obtained by updating the initial OD flow 1201 illustrated in FIG. 13 using Δq (correction value 2001 of OD flow q) calculated as in the above formula (10).

Next, the OD estimation device 201 sets the OD flow 2000 as the OD flow q (first OD flow). Then, the OD estimation device 201 returns to the Forward processing 1210 (refer to FIG. 12) and performs the first traffic simulation, using the OD flow q.

The OD estimation device 201 repeats the Forward processing 1210 and the Backward processing 1220 until the calculated error of the link flow (traffic volume) falls within the allowable range. Here, a case is assumed where an OD flow 1202 is estimated as a result of performing the repetition four times.

FIG. 21 is an explanatory diagram illustrating an OD flow estimation result in a coarse time frame. In FIG. 21, the OD flow 1202 indicates the OD flow estimation result in the coarse time frame (first time frame). The coarse time frame (first time frame) is a time frame for each 60 minutes.

· OD flow estimation in fine time frame

Next, the OD estimation device 201 estimates an OD flow in a fine time frame (second time frame) by the second traffic simulation. Here, the fine time frame (second time frame) is set to a time frame for each 30 minutes. Furthermore, there is a case where the fine time frames obtained by dividing the coarse time frame "6:00 to 7:00" at 30-minute intervals are referred to as "h1: 6:00 to 6:30" and "h2: 6:30 to 7:00". Furthermore, there is a case where the time frame "h1: 6:00 to 6:30" is simply referred to as the time frame h1 and the time frame "h2: 6:30 to 7:00" is simply referred to as the time frame h2.

Hereinafter, specific processing content when the OD flow in the fine time frame (second time frame) is estimated will be described.

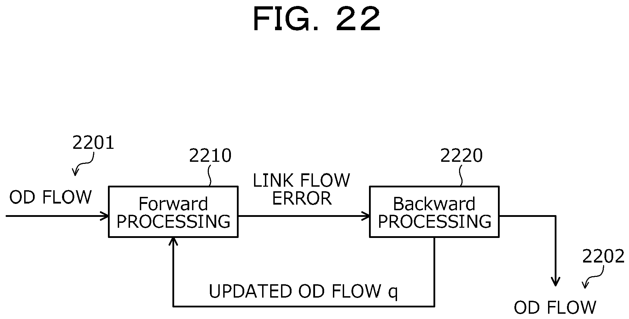

FIG. 22 is an explanatory diagram illustrating a second operation example of the OD estimation device 201. In FIG. 22, an operation repeatedly performed by the OD estimation device 201 when estimating the OD flow in the fine time frame (second time frame) is illustrated.

First, the OD estimation device 201 sets an OD flow 2201 to be given to the second traffic simulation as the initial value, based on the OD flow 1202 (OD flow in coarse time frame) illustrated in FIG. 21.

Specifically, for example, the OD estimation device 201 calculates the OD flow 2201, by distributing the OD flow 1202 (OD flow in coarse time frame) illustrated in FIG. 21 for each fine time frame (second time frame). Here, a case is assumed where the weight is set to 0.5 and the OD flow in the coarse time frame is distributed for each fine time frame (second time frame) at "1:1".

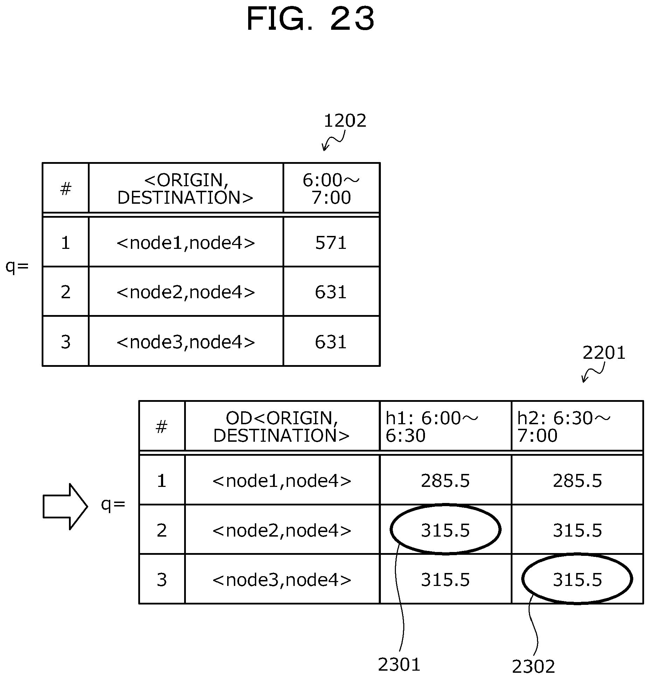

FIG. 23 is an explanatory diagram illustrating a distribution example of the OD flow. In FIG. 23, the OD flow 2201 indicates an OD flow calculated by distributing the OD flow 1202 (refer to FIG. 21) in the coarse time frame for each fine time frames.

For example, "315.5" indicated by a reference numeral 2301 indicates the number of vehicles (OD flow) that depart the node2 and reach the node4 in the time frame h1. Furthermore, "315.5" indicated by a reference numeral 2302 indicates the number of vehicles (OD flow) that depart the node3 and reach the node4 in the time frame h2.

Next, the OD estimation device 201 sets the OD flow 2201 to the OD flow q (second OD flow) in Forward processing 2210 (refer to FIG. 22). Then, the OD estimation device 201 performs the second traffic simulation, using the OD flow q.

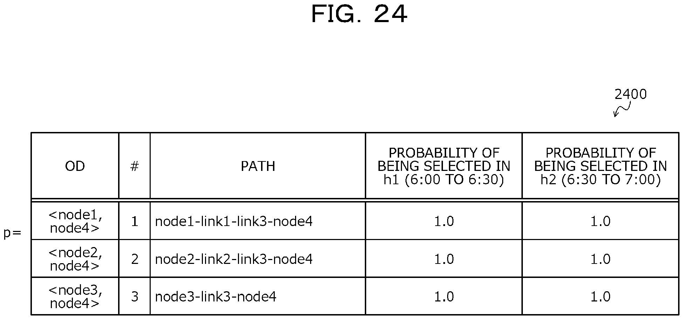

Specifically, for example, the OD estimation device 201 performs the second traffic simulation, by giving the road network table 500, the OD flow q (OD flow 2201), the path table 900, the OD pair table 800, and the path selection table (refer to FIG. 24) to the traffic simulator.

FIG. 24 is an explanatory diagram (part 2) illustrating a specific example of the path selection table. In FIG. 24, a path selection table 2400 indicates a probability (path selection probability) that a path (path) corresponding to each OD pair in the road network NW1 is selected in each of the time frame h1: 6:00 to 6:30 and the time frame h2: 6:30 to 7:00. The reference # in FIG. 24 is an identifier used to identify a path (path).

For example, a probability that the path1 (node1-link1-link3-node4) corresponding to the OD <node1, node4> is selected in the time frame h1: 6:00 to 6:30 is "1.0". Furthermore, a probability that the path3 (node3-link3-node4) corresponding to the OD <node3, node4> is selected in the time frame h2: 6:30 to 7:00 is "1.0".

In the second traffic simulation, for example, a virtual vehicle is caused to depart from the origin every five minutes during "6:00 to 7:00" and is caused to travel toward the destination. However, it is assumed that the vehicles that have departed within the same time frame reach the destination within the same time frame. For example, all the vehicles that have departed the node1 (origin) between "6:00 to 7:00" reach the node4 (destination) before "7:00". It is assumed that no congestion occur.

When the second traffic simulation is completed, a link flow (traffic volume) estimation result for each link included in the path (path) corresponding to each OD pair in each of the time frames h1 and h2 is obtained.

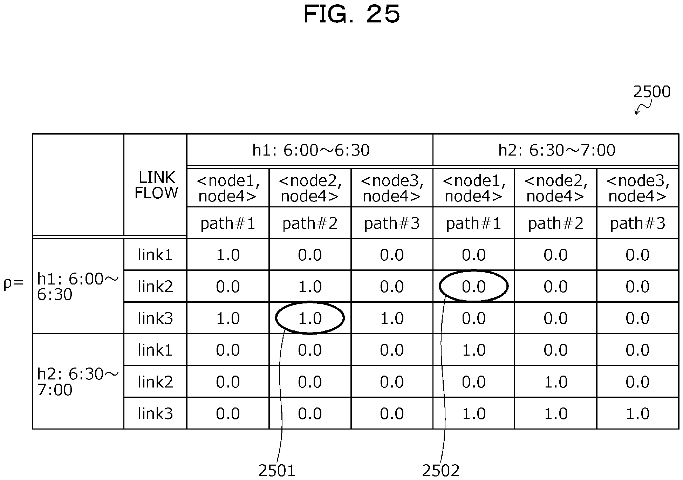

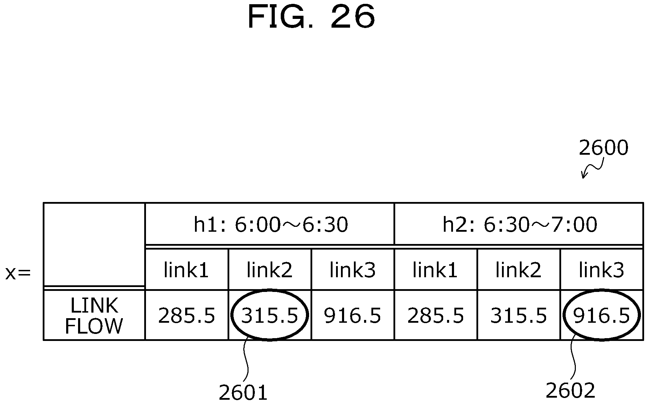

Here, a specific example of the link flow estimated by the second traffic simulation will be described with reference to FIGs. 25 and 26.

FIG. 25 is an explanatory diagram (part 2) illustrating a specific example of the link flow (ratio). In FIG. 25, a link flow 2500 is information ($\rho$) obtained by the second traffic simulation and represents a link flow (ratio) for each link included in the path (path) corresponding to each OD pair in each of the time frame h1: 6:00 to 6:30 and the time frame h2: 6:30 to 7:00.

The link flow (ratio) is a value according to the path selection probability of the path (path) corresponding to each OD pair in the path selection table 2400 illustrated in FIG. 24, for example.

For example, "1.0" indicated by a reference numeral 2501 indicates a ratio of vehicles that pass through the link3 in the time frame h1, among vehicles that pass through the path2 and travel from the node2 to the node4 in the time frame h1. Furthermore, "0.0" indicated by a reference numeral 2502 indicates a ratio of vehicles that pass through the link2 in the time frame h2, among vehicles that pass through the path1 and travel from the node1 to the node4 in the time frame h1.

The OD estimation device 201 calculates the link flow (traffic volume) based on the link flow 2500, for example, using the above formula (5). Here, when it is assumed that $\rho$ be the link flow 1500 illustrated in FIG. 25, x is calculated as in the following formula (13) and is a link flow 2600 illustrated in FIG. 26.

[Expression 4]

$$x = \rho p q$$

$$= \begin{bmatrix} 1.0 & 0.0 & 0.0 & 0.0 & 0.0 & 0.0 \\ 0.0 & 1.0 & 0.0 & 0.0 & 0.0 & 0.0 \\ 1.0 & 1.0 & 1.0 & 0.0 & 0.0 & 0.0 \\ 0.0 & 0.0 & 0.0 & 1.0 & 0.0 & 0.0 \\ 0.0 & 0.0 & 0.0 & 0.0 & 1.0 & 0.0 \\ 0.0 & 0.0 & 0.0 & 1.0 & 1.0 & 1.0 \end{bmatrix} \begin{bmatrix} 1.0 & 0.0 & 0.0 & 0.0 & 0.0 & 0.0 \\ 0.0 & 1.0 & 0.0 & 0.0 & 0.0 & 0.0 \\ 0.0 & 0.0 & 1.0 & 0.0 & 0.0 & 0.0 \\ 0.0 & 0.0 & 0.0 & 1.0 & 0.0 & 0.0 \\ 0.0 & 0.0 & 0.0 & 0.0 & 1.0 & 0.0 \\ 0.0 & 0.0 & 0.0 & 0.0 & 0.0 & 1.0 \end{bmatrix} \begin{bmatrix} 285.5 \\ 315.5 \\ 315.5 \\ 285.5 \\ 315.5 \\ 315.5 \end{bmatrix}$$

$$\dots (13)$$

FIG. 26 is an explanatory diagram (part 2) illustrating a specific example of the link flow (traffic volume). In FIG. 26, the link flow 2600 is information (x) estimated by the second traffic simulation and represents the link flow (traffic volume) for each link included in the path (path) corresponding to each OD pair, in each of the time frame h1: 6:00 to 6:30 and the time frame h2: 6:30 to 7:00.

For example, "315.5" indicated by a reference numeral 2601 indicates the number of vehicles that have passed through the link2 in the time frame h1. Furthermore, "916.5" indicated by a reference numeral 2602 indicates the number of vehicles that have passed through the link3 in the time frame h2. As a result, the OD estimation device 201 can estimate the traffic volumes (the number of vehicles) for all the links included in the path (path) corresponding to each OD pair.

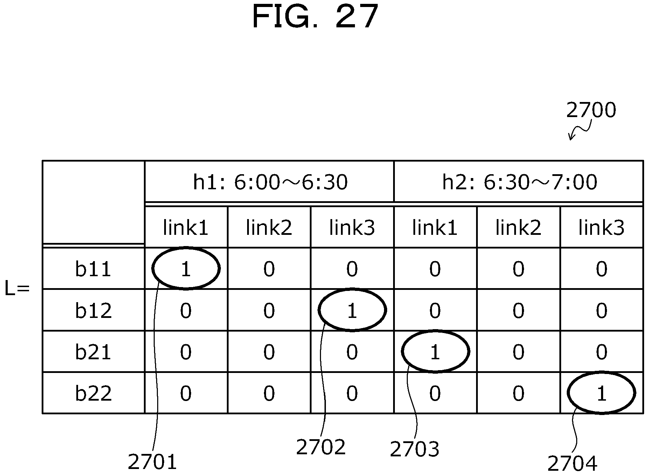

Next, the OD estimation device 201 extracts a traffic volume of a link where the traffic volume can be actually observed. Here, it is assumed that the sensors (vehicle counter) be provided only for the link1 and the link3 in the road network NW1. Therefore, the OD estimation device 201 extracts the link where the traffic volume can be observed from the road network NW1, using an observation matrix 2700 illustrated in FIG. 27.

FIG. 27 is an explanatory diagram (part 2) illustrating an example of the observation matrix. In FIG. 27, the observation matrix 2700 is a matrix for extracting the link1 and the link3 where the traffic volume can be observed in each of the time frames h1 and h2, from among the link1, the link2, and the link3 in the road network NW1.

For example, "1" indicated by a reference numeral 2701 is a flag indicating that the traffic volume (the number of vehicles) that passes through the link1 in the time frame h1 can be observed. Furthermore, "1" indicated by a reference numeral 2702 is a flag indicating that a traffic volume that passes through the link3 in the time frame h1 can be observed. Furthermore, "1" indicated by a reference numeral 2703 is a flag indicating that a traffic volume that passes through the link1 in the time frame h2 can be observed. Furthermore, "1" indicated by a reference numeral 2704 is a flag indicating that a traffic volume that passes through the link3 in the time frame h2 can be observed.

Note that, in FIG. 27, b11 corresponds to information used to extract the link1 in the time frame h1. The reference numeral b12 corresponds to information used to extract the link3 in the time frame h1. The reference numeral b21 corresponds to information used to extract the link1 in the time frame h2. The reference numeral b22 corresponds to information used to extract the link3 in the time frame h2.

The OD estimation device 201 extracts the link flows (traffic volume) of the link1 and the link3 where the traffic volume can be observed in each of the time frames h1 and h2, from among the link1, the link2, and the link3 in the road network NW1, for example, using the above formula (7).

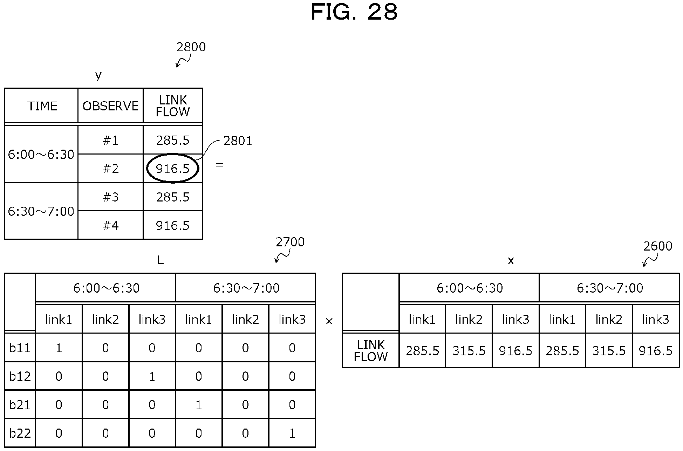

Here, when it is assumed that x be the link flow 2600 illustrated in FIG. 26 and L be the observation matrix 2700 illustrated in FIG. 27, y is calculated as in the following formula (14), and a link flow 2800 illustrated in FIG. 28 is extracted.

[Expression 5]

$$y = Lx = \begin{bmatrix} 1 & 0 & 0 & 0 & 0 & 0 \\ 0 & 0 & 1 & 0 & 0 & 0 \\ 0 & 0 & 0 & 1 & 0 & 0 \\ 0 & 0 & 0 & 0 & 0 & 1 \end{bmatrix} \begin{bmatrix} 285.5 \\ 315.5 \\ 916.5 \\ 285.5 \\ 315.5 \\ 916.5 \end{bmatrix} = \begin{bmatrix} 285.5 \\ 916.5 \\ 285.5 \\ 916.5 \end{bmatrix} \dots (14)$$

FIG. 28 is an explanatory diagram (part 2) illustrating a specific example of the observable link flow (traffic volume). In FIG. 28, the link flow 2800 represents the link flows (traffic volume) of the link1 and the link3 that have actually observed in the respective time frame h1: 6:00 to 6:30 and the time frame h2: 6:30 to 7:00.

For example, "916.5" indicated by a reference numeral 2801 indicates the number of vehicles that have passed through the link3 in the time frame h1. The reference numeral # in FIG. 28 is an identifier used to identify the observed link flow (traffic volume).

Next, the OD estimation device 201 calculates an error between the link flow (traffic volume) calculated (estimated) on the simulator and the actually observed link flow (traffic volume), for example, using the above formula (9).

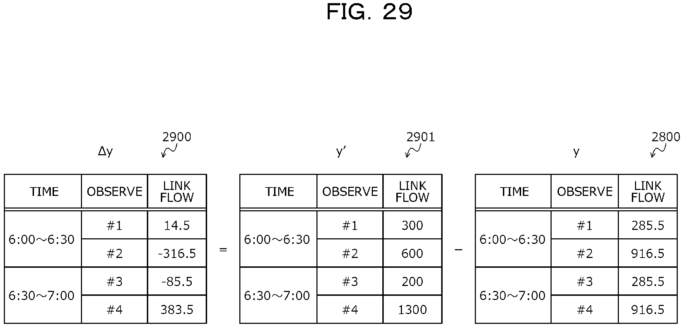

Here, when it is assumed that y be the link flow 2800 illustrated in FIG. 28, Δy is calculated as illustrated in FIG. 29. The reference numeral y' is specified from the link flow observation data.

FIG. 29 is an explanatory diagram (part 2) illustrating a specific example of the error of the link flow (traffic volume). In FIG. 29, an error 2900 of the link flow (traffic volume) represents an error between the link flows (traffic volume) of the links 1 and 3 where the traffic volume can be observed, in the respective time frames h1: 6:00 to 6:30 and the time frame h2: 6:30 to 7:00. Note that a link flow 2901 is a link flow (traffic volume) that is actually observed and is specified from the link flow observation data.

Here, a case is assumed where the calculated error 2900 of the link flow (traffic volume) is not within a predetermined allowable range.

In this case, the OD estimation device 201 updates the OD flow q, based on the error 2900 of the link flow (traffic volume), in Backward processing 2220 (refer to FIG. 22). The OD flow q before the update at this point is the OD flow 2201 illustrated in FIG. 23.

Specifically, for example, first, the OD estimation device 201 calculates the correction value of the OD flow q, using the above formula (10). Here, w is set to "w = 0.5", p is set to the path selection table 2400 illustrated in FIG. 24, ρ is set to the link flow 2500 illustrated in FIG. 25, L is set to the observation matrix 2700 illustrated in FIG. 27, and Δy is set to the error 2900 of the link flow (traffic volume) illustrated in FIG. 29. In this case, Δq is calculated as in the following formula (15).

[Expression 6]

$$\Delta q = wp^T \rho^T L^t \Delta y$$

$$= 0.5 * \begin{bmatrix} 1. & 0. & 0. & 0. & 0. & 0. \\ 0. & 1. & 0. & 0. & 0. & 0. \\ 0. & 0. & 1. & 0. & 0. & 0. \\ 0. & 0. & 0. & 1. & 0. & 0. \\ 0. & 0. & 0. & 0. & 1. & 0. \\ 0. & 0. & 0. & 0. & 0. & 1. \end{bmatrix} \begin{bmatrix} 1. & 0. & 1. & 0. & 0. & 0. \\ 0. & 1. & 1. & 0. & 0. & 0. \\ 0. & 0. & 1. & 0. & 0. & 0. \\ 0. & 0. & 0. & 1. & 0. & 1. \\ 0. & 0. & 0. & 0. & 1. & 1. \\ 0. & 0. & 0. & 0. & 0. & 1. \end{bmatrix} \begin{bmatrix} 1 & 0 & 0 & 0 \\ 0 & 0 & 0 & 0 \\ 0 & 1 & 0 & 0 \\ 0 & 0 & 1 & 0 \\ 0 & 0 & 0 & 0 \\ 0 & 0 & 0 & 1 \end{bmatrix} \begin{bmatrix} -151. \\ -158.25 \\ -158.25 \\ 149.25 \\ 191.75 \\ 191.75 \end{bmatrix}$$

$$= \begin{bmatrix} -151. \\ -158.25 \\ -158.25 \\ 149.25 \\ 191.75 \\ 191.75 \end{bmatrix} \dots (15)$$

Next, the OD estimation device 201 updates the OD flow q, for example, using the above formula (12).

Here, when Δq is set to a value calculated as in the above formula (15), the OD flow q is updated as illustrated in FIG. 30.

FIG. 30 is an explanatory diagram (part 2) illustrating an update example of the OD flow. In FIG. 30, an OD flow 3000 is an updated OD flow q obtained by updating the OD flow 2201 illustrated in FIG. 23 using Δq (correction value 3001 of OD flow q) calculated as in the above formula (14).

Next, the OD estimation device 201 sets the OD flow 3000 as the OD flow q (second OD flow). Then, the OD estimation device 201 returns to the Forward processing 2210 (refer to FIG. 22) and performs the second traffic simulation, using the OD flow q.

The OD estimation device 201 repeats the Forward processing 2210 and the Backward processing 2220 until the calculated error of the link flow (traffic volume) falls within the allowable range. Here, a case is assumed where the OD flow 2202 is estimated as a result of performing the repetition 10 times.

FIG. 31 is an explanatory diagram illustrating an OD flow estimation result in a fine time frame. In FIG. 31, the OD flow 2202 indicates the OD flow estimation result in the fine time frame (second time frame). The fine time frame (second time frame) is a time frame for each 30 minutes.

As a result, the OD estimation device 201 can suppress a processing time taken to estimate the OD flow and estimate the OD flow in the fine time frame (second time frame).

(OD Determination Processing Procedure of OD Estimation Device 201)

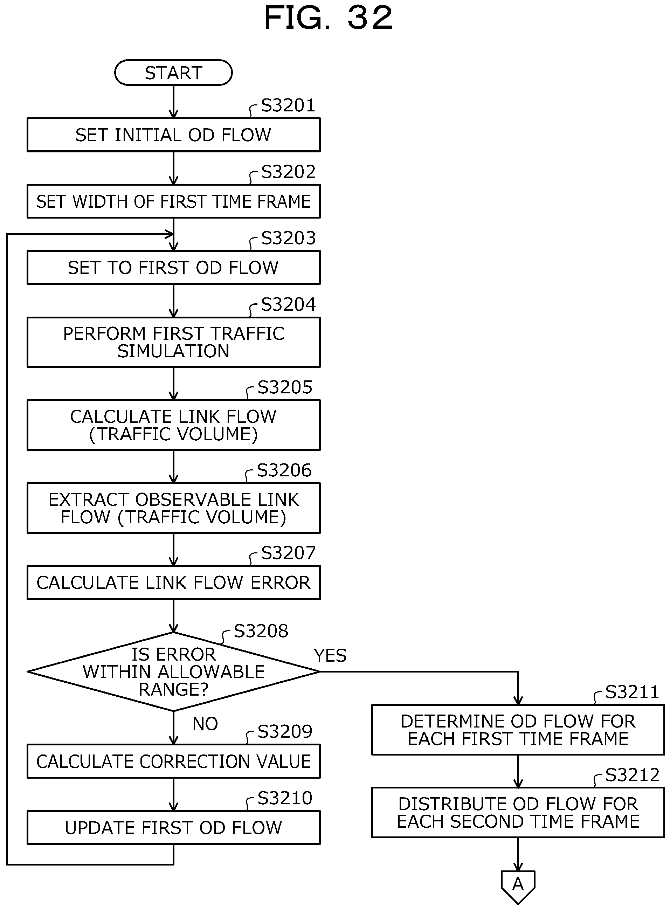

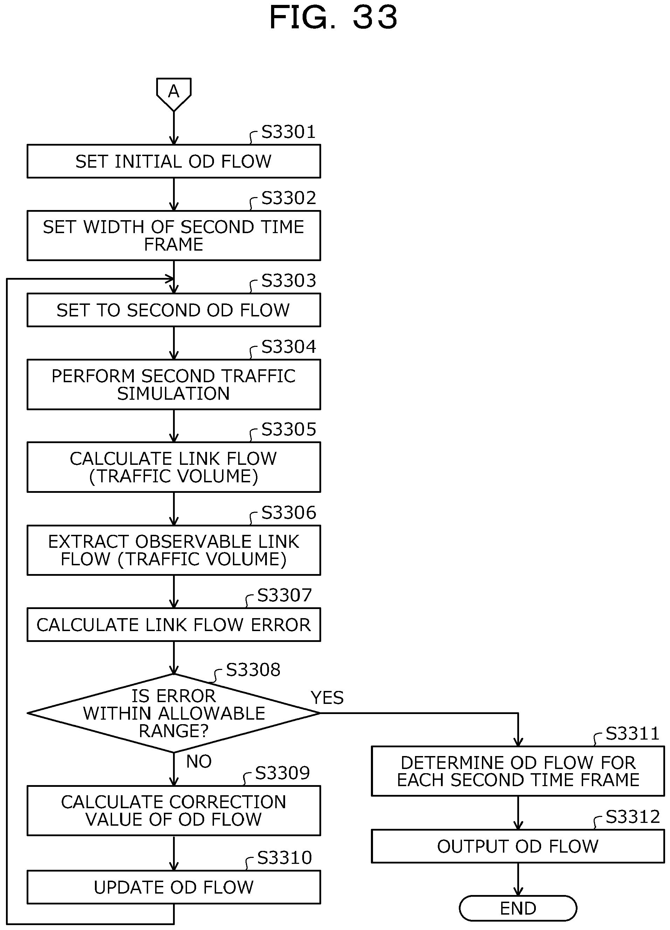

Next, an OD determination processing procedure of the OD estimation device 201 will be described with reference to FIGs. 32 and 33.

FIGs. 32 and 33 are flowcharts illustrating an example of the OD determination processing procedure of the OD estimation device 201. In the flowchart in FIG. 32, first, the OD estimation device 201 sets the initial OD flow when performing the first traffic simulation (step S3201).

Next, the OD estimation device 201 sets the width (time width) of the first time frame in the first traffic simulation (step S3202). A width of the time frame of the initial OD flow is set as the width of the first time frame.

Then, the OD estimation device 201 sets the initial OD flow as the first OD flow (step S3203) and performs the first traffic simulation using the first OD flow (step S3204). Next, the OD estimation device 201 calculates the link flow (traffic volume) for each first time frame from the link flow (ratio) for each first time frame obtained by the first traffic simulation (step S3205).

Then, the OD estimation device 201 extracts the link flow (traffic volume) of the link where the traffic volume can be observed, from the calculated link flow (traffic volume) (step S3206). Next, the OD estimation device 201 calculates the error between the extracted link flow (traffic volume) of the link and the link flow (traffic volume) that has been actually observed for the link (step S3207). The actually observed link flow (traffic volume) is specified from the link flow observation data.

Then, the OD estimation device 201 determines whether or not the calculated error of the link flow (traffic volume) is within the allowable range (step S3208). Here, in a case where the error is not within the allowable range (step S3208: No), the OD estimation device 201 calculates the correction value of the first OD flow based on the calculated error (step S3209).

Next, the OD estimation device 201 updates the first OD flow, using the calculated correction value (step S3210). Then, the OD estimation device 201 returns to step S3203, sets the updated first OD flow as the first OD flow, and executes the subsequent processing.

Furthermore, in a case where the calculated error of the link flow (traffic volume) is within in the allowable range in step S3208 (step S3208: Yes), the OD estimation device 201 determines the first OD flow used for the immediately preceding first traffic simulation as the OD flow for each first time frame (step S3211).

Then, the OD estimation device 201 calculates the second OD flow by distributing the determined OD flow for each first time frame for each the second time frame obtained by dividing the first time frame (step S3212) and proceeds to step S3301 illustrated in FIG. 33.

In the flowchart in FIG. 33, first, the OD estimation device 201 sets the initial OD flow when performing the second traffic simulation (step S3301). As the initial OD flow, the second OD flow calculated in step S3212 illustrated in FIG. 32 is set.

Next, the OD estimation device 201 sets the width of the second time frame in the second traffic simulation (step S3302). Then, the OD estimation device 201 sets the initial OD flow as the second OD flow (step S3303) and performs the second traffic simulation using the second OD flow (step S3304).

Next, the OD estimation device 201 calculates the link flow (traffic volume) for each second time frame from the link flow (ratio) for each second time frame obtained by the second traffic simulation (step S3305). Then, the OD estimation device 201 extracts the link flow (traffic volume) of the link where the traffic volume can be observed, from the calculated link flow (traffic volume) (step S3306).

Next, the OD estimation device 201 calculates the error between the extracted link flow (traffic volume) of the link and the link flow (traffic volume) that has been actually observed for the link (step S3307). Then, the OD estimation device 201 determines whether or not the calculated error of the link flow (traffic volume) is within the allowable range (step S3308).

Here, in a case where the error is not within the allowable range (step S3308: No), the OD estimation device 201 calculates the correction value of the second OD flow based on the calculated error (step S3309). Next, the OD estimation device 201 updates the second OD flow, using the calculated correction value (step S3310).

Then, the OD estimation device 201 returns to step S3303, sets the updated second OD flow as the second OD flow, and executes the subsequent processing.

Furthermore, in a case where the calculated error of the link flow (traffic volume) is within in the allowable range in step S3308 (step S3308: Yes), the OD estimation device 201 determines the second OD flow used for the immediately preceding second traffic simulation as the OD flow for each second time frame (step S3311).

Then, the OD estimation device 201 outputs the determined OD flow for each second time frame (step S3312) and ends the series of processing according to the present flowchart.

As a result, the OD estimation device 201 can estimate the OD flow in the fine time frame (second time frame), using the OD flow estimated in the coarse time frame (first time frame).

As described above, according to the OD estimation device 201 according to the embodiment, it is possible to perform the first traffic simulation for estimating the traffic volume for each link included in the path from the first point to the second point, using the first OD flow, for each first time frame obtained by dividing the target period. The first OD flow represents the traffic volume (for example, the number of vehicles) that has departed the first point and reached the second point in the first time frame. Then, according to the OD estimation device 201, it is possible to determine the OD flow for each first time frame, for the pair (OD pair) of the first point and the second point, by repeatedly performing the first traffic simulation while adjusting the first OD flow, so as to reduce the error between the estimated traffic volume of the link and the traffic volume that has been observed for the link.

As a result, the OD estimation device 201 can estimate the OD flow in the time frame (first time frame) coarser than the time frame that is originally intended to be estimated, for the OD pair of the origin (O) and the destination (D). In the OD flow estimation in the coarse time frame, even if the number of repetitions before the optimal solution is obtained increases, a handling matrix size (L, $\rho$, p, q) is relatively small. Therefore, it can be expected that a processing time taken to perform one repetition is shortened.

Furthermore, according to the OD estimation device 201, it is possible to calculate the second OD flow that has departed the first point and reached the second point in the second time frame, for each second time frame obtained by dividing the first time frame, based on the determined OD flow for each first time frame. The calculated second OD flow corresponds to the initial OD flow of the second traffic simulation. Furthermore, according to the OD estimation device 201, it is possible to perform the second traffic simulation for estimating the traffic volume for each link, for each second time frame, using the calculated second OD flow. Then, according to the OD estimation device 201, it is possible to determine the OD flow for each second time frame, for the pair of the first point and the second point, by repeatedly performing the second traffic simulation while adjusting the second OD flow, so as to reduce the error between the estimated traffic volume of the link and the traffic volume that has been observed for the link.

As a result, the OD estimation device 201 can estimate the OD flow in the time frame (second time frame) that is originally intended to be estimated, using the OD flow in the coarse time frame (first time frame), for the OD pair of the origin (O) and the destination (D). The OD estimation device 201 can reduce the number of repetitions before the optimal solution is obtained, by using the OD flow estimated in the coarse time frame, as an initial value of the OD flow estimation in the fine time frame.

Furthermore, according to the OD estimation device 201, it is possible to calculate the second OD flow, by distributing the determined OD flow for each first time frame for each second time frame according to the predetermined ratio.

As a result, the OD estimation device 201 can distribute the OD flow for each first time frame into the second time frames divided from the first time frame and use the OD flow.

Furthermore, according to the OD estimation device 201, it is possible to output the determined OD flow for each second time frame, in association with the pair (OD pair) of the first point and the second point.

As a result, the OD estimation device 201 can output the OD flow in the fine time frame (second time frame) as the OD estimation result, for the OD pair of the origin (O) and the destination (D).

Furthermore, according to the OD estimation device 201, it is possible to calculate the second OD flow, by distributing the determined OD flow for each first time frame for each second time frame, according to a ratio set based on the time widths of the first time frame and the second time frame.

As a result, the OD estimation device 201 can distribute the OD flow for each first time frame into the second time frames according to the ratio between the time widths of the first time frame and the second time frame and use the OD flow. For example, in a case where the ratio between the time widths of the first time frame and the second time frame is °2:1", the OD flow obtained by dividing the first time frame into two is distributed to each second time frame. Therefore, the OD estimation device 201 can enhance calculation accuracy of the OD flow used as the initial value of the second traffic simulation.

Furthermore, according to the OD estimation device 201, it is possible to calculate the second OD flow, by distributing the determined OD flow for each first time frame for each second time frame, according to the ratio set based on the traffic volume for each second time frame, observed for the first link included in the path from the first point to the second point. The first link is, for example, a link coupled to the first point.

As a result, the OD estimation device 201 can distribute the OD flow for each first time frame into the second time frames according to the ratio of the link flows (traffic volume) that have been actually observed for the respective second time frames and use the OD flow. Therefore, the OD estimation device 201 can enhance calculation accuracy of the OD flow used as the initial value of the second traffic simulation.

Furthermore, the OD estimation device 201 calculates the error between the traffic volume of the link estimated by the first traffic simulation and the traffic volume observed for the link and determines whether or not the calculated error is within the allowable range. In a case where the error is not within the allowable range, the OD estimation device 201 can update the first OD flow based on the error and perform the first traffic simulation using the updated first OD flow. Then, according to the OD estimation device 201, in a case where the calculated error is within the allowable range, the first OD flow used for the immediately preceding first traffic simulation can be determined as the OD flow for each first time frame.

As a result, the OD estimation device 201 can repeat the first traffic simulation while updating the first OD flow, until the error between the link flow estimated by the first traffic simulation and the actually observed link flow falls within the allowable range.

Furthermore, the OD estimation device 201 calculates the error between the traffic volume of the link estimated by the second traffic simulation and the traffic volume observed for the link and determines whether or not the calculated error is within the allowable range. In a case where the error is not within the allowable range, the OD estimation device 201 can update the second OD flow based on the error and perform the second traffic simulation using the updated second OD flow. Then, according to the OD estimation device 201, in a case where the calculated error is within the allowable range, the second OD flow used for the immediately preceding second traffic simulation can be determined as the OD flow for each second time frame.

As a result, the OD estimation device 201 can repeat the second traffic simulation while updating the second OD flow, until the error between the link flow estimated by the second traffic simulation and the actually observed link flow falls within the allowable range.

From these, according to the OD estimation device 201, it is possible to estimate the OD flow in the fine time frame, using the OD flow estimated in the coarse time frame. As a result, it is possible to greatly shorten a processing time taken to estimate an OD flow in a desired time frame.

For example, since the OD estimation device 201 can reduce a handling matrix size in a layer in which the width of the time frame is large as compared with a layer in which the width of the time frame is small, the OD estimation device 201 can shorten an overall processing time. Furthermore, since the OD flow already approaches a value close to a true value in the layer in which the width of the time frame is small, the OD estimation device 201 can reduce the number of repetitions taken before being optimized.

Furthermore, according to the present OD determination method, it is possible to estimate the OD flow (traffic volume) in the fine time frame in a short time and with high accuracy. Therefore, for example, it is possible to provide a service for estimating the OD flow with a cloud. Furthermore, in a company that provides ride-hailing such as a transportation station or a taxi, it is possible to use the OD estimation result to improve transportation measures and services.

Note that the OD determination method described in the present embodiment may be implemented by a computer such as a personal computer or a workstation executing a program prepared in advance. The OD determination program is recorded in a computer-readable recording medium such as a hard disk, a flexible disk, a CD-ROM, a DVD, or a USB memory, and is read from the recording medium to be executed by a computer. Furthermore, the OD determination program may be distributed via a network such as the Internet.

Furthermore, the OD estimation device 201 described in the present embodiment may also be implemented by a special-purpose integrated circuit (IC) such as a standard cell or a structured application specific integrated circuit (ASIC) or a programmable logic device (PLD) such as a field-programmable gate array (FPGA).

**Claims**

1. An origin destination (OD) determination method in which a computer executes processing comprising:

   performing a first traffic simulation that estimates a traffic volume for each link included in a path from a first point to a second point, by using a first OD traffic volume that has departed from the first point and reached the second point in a first time frame, for each first time frame obtained by dividing a target period;
   determining an OD traffic volume for each first time frame, for a pair of the first point and the second point, by repeatedly performing the first traffic simulation while adjusting the first OD traffic volume, so as to reduce an error between the estimated traffic volume of the link and a traffic volume observed for the link;
   calculating a second OD traffic volume that has departed from the first point and reached the second point in a second time frame, for each second time frame obtained by dividing the first time frame, based on the determined OD traffic volume for each first time frame;
   performing a second traffic simulation that estimates a traffic volume for each link, for each second time frame, by using the calculated second OD traffic volume; and
   determining an OD traffic volume for each second time frame, for the pair of the first point and the second point, by repeatedly performing the second traffic simulation while adjusting the second OD traffic volume, so as to reduce an error between the estimated traffic volume of the link and a traffic volume observed for the link.

2. The OD determination method according to claim 1, wherein

   the calculating processing
   calculates the second OD traffic volume, by distributing the determined OD traffic volume for each first time frame for each second time frame according to a predetermined ratio.

3. The OD determination method according to claim 1 in which the computer executes processing comprising:
   outputting the determined OD traffic volume for each second time frame, in association with the pair of the first point and the second point.

4. The OD determination method according to claim 2, wherein the ratio is set based on time widths of the first time frame and the second time frame.

5. The OD determination method according to claim 2, wherein the ratio is set based on the traffic volume for each second time frame, observed for a first link included in the path.

6. The OD determination method according to claim 5, wherein the first link is a link coupled to the first point.

7. The OD determination method according to claim 1, wherein

   the processing of determining the OD traffic volume for each first time frame
   calculates an error between the traffic volume of the link estimated by the first traffic simulation and the traffic volume observed for the link and determines whether or not the calculated error is within an allowable range,
   in a case where the error is not within the allowable range, updates the first OD traffic volume based on the error and performs the first traffic simulation by using the updated first OD traffic volume, and
   in a case where the calculated error is within the allowable range, determines the first OD traffic volume used for the immediately preceding first traffic simulation as the OD traffic volume for each first time frame.

8. The OD determination method according to claim 1, wherein

the processing of determining the OD traffic volume for each second time frame calculates an error between the traffic volume of the link estimated by the second traffic simulation and the traffic volume observed for the link and determines whether or not the calculated error is within an allowable range, in a case where the error is not within the allowable range, updates the second OD traffic volume based on the error and performs the second traffic simulation by using the updated second OD traffic volume, and in a case where the calculated error is within the allowable range, determines the second OD traffic volume used for the immediately preceding second traffic simulation as the OD traffic volume for each second time frame.

9. An origin destination (OD) determination program causing a computer to execute a process of:

performing a first traffic simulation that estimates a traffic volume for each link included in a path from a first point to a second point, by using a first OD traffic volume that has departed from the first point and reached the second point in a first time frame, for each first time frame obtained by dividing a target period; determining an OD traffic volume for each first time frame, for a pair of the first point and the second point, by repeatedly performing the first traffic simulation while adjusting the first OD traffic volume, so as to reduce an error between the estimated traffic volume of the link and a traffic volume observed for the link; calculating a second OD traffic volume that has departed from the first point and reached the second point in a second time frame, for each second time frame obtained by dividing the first time frame, based on the determined OD traffic volume for each first time frame; performing a second traffic simulation that estimates a traffic volume for each link, for each second time frame, by using the calculated second OD traffic volume; and determining an OD traffic volume for each second time frame, for the pair of the first point and the second point, by repeatedly performing the second traffic simulation while adjusting the second OD traffic volume, so as to reduce an error between the estimated traffic volume of the link and a traffic volume observed for the link.

FIG. 1

FIRST OD TRAFFIC VOLUME q1

q1_1

6:00  7:00  8:00  ...  11:00

q2_1  q2_2

6:00  6:30  7:00  7:30  8:00  ...  11:00

101

FIRST TIME FRAME

110

FIRST SIMULATION — LINK ERROR → FIRST OD TRAFFIC VOLUME UPDATE

UPDATED FIRST OD TRAFFIC VOLUME q1

111

SECOND OD TRAFFIC VOLUME q2

SECOND TIME FRAME

120

SECOND SIMULATION — LINK ERROR → SECOND OD TRAFFIC VOLUME UPDATE

UPDATED SECOND OD TRAFFIC VOLUME q2

121

# FIG. 2

# FIG. 3

201

304
DISK

301
CPU

302
MEMORY

303
DISK DRIVE

300

305
COMMUNICATION I/F

306
PORTABLE RECORDING MEDIUM I/F

210
NETWORK

307
PORTABLE RECORDING MEDIUM

# FIG. 4

# FIG. 5

500

| | node1 | node2 | node3 | node4 |
|---|---|---|---|---|
| node1 | None | None | **link1** | None |
| node2 | None | None | **link2** | None |
| node3 | None | None | None | **link3** |
| node4 | None | None | None | None |

# FIG. 6

600

| # | O(Origin) |
|---|-----------|
| 1 | node1 |
| 2 | node2 |
| 3 | node3 |

# FIG. 7

700

| # | D(Destination) |
|---|---|
| 1 | node4 |

# FIG. 8

800

| # | OD(Origin-Destination) |
|---|---|
| 1 | \<node1,node4\> |
| 2 | \<node2,node4\> |
| 3 | \<node3,node4\> |

# FIG. 9

900

| OD | # | path |
|---|---|---|
| <node1,node4> | 1 | node1-link1-link3-node4 |
| <node2,node4> | 2 | node2-link2-link3-node4 |
| <node3,node4> | 3 | node3-link3-node4 |

FIG. 10

201

1000

CONTROL UNIT

1001

ACQUISITION UNIT

1002

SETTING UNIT

1003

FIRST EXECUTION UNIT

1004

FIRST DETERMINATION UNIT

1005

CALCULATION UNIT

1006

SECOND EXECUTION UNIT

1007

SECOND DETERMINATION UNIT

1008

OUTPUT UNIT

OD ESTIMATION DEVICE

# FIG. 11

<FIRST TIME FRAME>

q1_0   q2_0   ...

6:00   7:00   8:00   11:00

$$q1\_1=q1\_0*w1$$
$$q2\_1=q1\_0*(1.0-w1)$$
$$q3\_1=q2\_0*w2$$
$$q4\_1=q2\_0*(1.0-w2)$$
...

<SECOND TIME FRAME>

q1_1   q2_1   q3_1   q4_1   ...

6:00   6:30   7:00   7:30   8:00   11:00

# FIG. 12

# FIG. 13

1201

q=

| # | OD<ORIGIN, DESTINATION> | h1: 6:00～7:00 |
|---|---|---|
| 1 | <node1,node4> | 2 |
| 2 | <node2,node4> | 2 |
| 3 | <node3,node4> | 2 |

1301

# FIG. 14

1400

| | OD | # | path | PROBABILITY OF BEING SELECTED IN h1: 6:00 TO 7:00 |
|---|---|---|---|---|
| p= | <node1, node4> | 1 | node1-link1-link3-node4 | 1.0 |
| | <node2, node4> | 2 | node2-link2-link3-node4 | 1.0 |
| | <node3, node4> | 3 | node3-link3-node4 | 1.0 |

# FIG. 15

1500

| | LINK FLOW (RATIO) | h1: 6:00∼7:00 | | |
|---|---|---|---|---|
| | | <node1, node4> | <node2, node4> | <node3, node4> |
| | | path1 | path2 | path3 |
| h1: 6:00∼7:00 | link1 | 1.0 | 0.0 | 0.0 |
| | link2 | 0.0 | 1.0 | 0.0 |
| | link3 | 1.0 | 1.0 | 1.0 |

ρ=

1501

1502

# FIG. 16

1600

| | h1: 6:00〜7:00 | | |
| --- | --- | --- | --- |
| | link1 | link2 | link3 |
| LINK FLOW | 2 | 2 | 6 |

1601

# FIG. 17

1700

L=

| | h1: 6:00~7:00 | | |
|---|---|---|---|
| | link1 | link2 | link3 |
| b11(h1,link1) | 1 | 0 | 0 |
| b12(h1,link3) | 0 | 0 | 1 |

1701

FIG. 18

y    1800

| TIME | OBSERVE | link FLOW |
|---|---|---|
| 6:00~7:00 | #1 | 2 |
| | #2 | 6 |

1801

=

L    1700

| | | 6:00~7:00 | | |
|---|---|---|---|---|
| | | link1 | link2 | link3 |
| b11 | | 1 | 0 | 0 |
| b11 | | 0 | 0 | 1 |

×

x    1600

| | | 6:00~7:00 | | |
|---|---|---|---|---|
| | | link1 | link2 | link3 |
| LINK FLOW | | 2 | 2 | 6 |

# FIG. 19

Δy    1900

| TIME | OBSERVE | LINK FLOW |
|------|---------|-----------|
| 6:00~7:00 | #1 | 498 |
| | #2 | 1894 |

=

y′    1901

| TIME | OBSERVE | LINK FLOW |
|------|---------|-----------|
| 6:00~7:00 | #1 | 500 |
| | #2 | 1900 |

−

y    1800

| TIME | OBSERVE | LINK FLOW |
|------|---------|-----------|
| 6:00~7:00 | #1 | 2 |
| | #2 | 6 |

# FIG. 20

q                    2000

| # | <ORIGIN, DESTINATION> | 6:00～ 7:00 |
|---|---|---|
| 1 | <node1, node4> | 1198 |
| 2 | <node2, node4> | 949 |
| 3 | <node3, node4> | 949 |

=

Δq                   2001

| # | <ORIGIN, DESTINATION> | 6:00～ 7:00 |
|---|---|---|
| 1 | <node1, node4> | 1196 |
| 2 | <node2, node4> | 947 |
| 3 | <node3, node4> | 947 |

+

q                    1201

| # | <ORIGIN, DESTINATION> | 6:00～ 7:00 |
|---|---|---|
| 1 | <node1, node4> | 2 |
| 2 | <node2, node4> | 2 |
| 3 | <node3, node4> | 2 |

# FIG. 21

1202

| # | <ORIGIN, DESTINATION> | 6:00~7:00 |
|---|---|---|
| 1 | <node1,node4> | 571 |
| 2 | <node2,node4> | 631 |
| 3 | <node3,node4> | 631 |

# FIG. 22

OD FLOW → **Forward PROCESSING** (2210) → LINK FLOW ERROR → **Backward PROCESSING** (2220) → OD FLOW (2202)

UPDATED OD FLOW q

2201

# FIG. 23

1202

q=

| # | <ORIGIN, DESTINATION> | 6:00~7:00 |
|---|---|---|
| 1 | <node1,node4> | 571 |
| 2 | <node2,node4> | 631 |
| 3 | <node3,node4> | 631 |

2201

q=

| # | OD<ORIGIN, DESTINATION> | h1: 6:00~6:30 | h2: 6:30~7:00 |
|---|---|---|---|
| 1 | <node1,node4> | 285.5 | 285.5 |
| 2 | <node2,node4> | 315.5 | 315.5 |
| 3 | <node3,node4> | 315.5 | 315.5 |

2301          2302

# FIG. 24

2400

p=

| OD | # | PATH | PROBABILITY OF BEING SELECTED IN h1 (6:00 TO 6:30) | PROBABILITY OF BEING SELECTED IN h2 (6:30 TO 7:00) |
|---|---|---|---|---|
| <node1, node4> | 1 | node1-link1-link3-node4 | 1.0 | 1.0 |
| <node2, node4> | 2 | node2-link2-link3-node4 | 1.0 | 1.0 |
| <node3, node4> | 3 | node3-link3-node4 | 1.0 | 1.0 |

# FIG. 25

2500

| | | LINK FLOW | h1: 6:00～6:30 | | | h2: 6:30～7:00 | | |
|---|---|---|---|---|---|---|---|---|
| | | | \<node1, node4\> | \<node2, node4\> | \<node3, node4\> | \<node1, node4\> | \<node2, node4\> | \<node3, node4\> |
| | | | path#1 | path#2 | path#3 | path#1 | path#2 | path#3 |
| ρ= | h1: 6:00～6:30 | link1 | 1.0 | 0.0 | 0.0 | 0.0 | 0.0 | 0.0 |
| | | link2 | 0.0 | 1.0 | 0.0 | 0.0 | 0.0 | 0.0 |
| | | link3 | 1.0 | 1.0 | 1.0 | 0.0 | 0.0 | 0.0 |
| | h2: 6:30～7:00 | link1 | 0.0 | 0.0 | 0.0 | 1.0 | 0.0 | 0.0 |
| | | link2 | 0.0 | 0.0 | 0.0 | 0.0 | 1.0 | 0.0 |
| | | link3 | 0.0 | 0.0 | 0.0 | 1.0 | 1.0 | 1.0 |

2501          2502

# FIG. 26

2600

| x= | | h1: 6:00~6:30 | | | h2: 6:30~7:00 | | |
|---|---|---|---|---|---|---|---|
| | | link1 | link2 | link3 | link1 | link2 | link3 |
| | LINK FLOW | 285.5 | 315.5 | 916.5 | 285.5 | 315.5 | 916.5 |

2601                2602

# FIG. 27

2700

L=

| | h1: 6:00~6:30 | | | h2: 6:30~7:00 | | |
|---|---|---|---|---|---|---|
| | link1 | link2 | link3 | link1 | link2 | link3 |
| b11 | 1 | 0 | 0 | 0 | 0 | 0 |
| b12 | 0 | 0 | 1 | 0 | 0 | 0 |
| b21 | 0 | 0 | 0 | 1 | 0 | 0 |
| b22 | 0 | 0 | 0 | 0 | 0 | 1 |

2701    2702    2703    2704

# FIG. 28

2800

| TIME | OBSERVE | LINK FLOW |
|---|---|---|
| 6:00~6:30 | #1 | 285.5 |
| | #2 | 916.5 |
| 6:30~7:00 | #3 | 285.5 |
| | #4 | 916.5 |

2801

y

=

L 2700

| | 6:00~6:30 | | | 6:30~7:00 | | |
|---|---|---|---|---|---|---|
| | link1 | link2 | link3 | link1 | link2 | link3 |
| b11 | 1 | 0 | 0 | 0 | 0 | 0 |
| b12 | 0 | 0 | 1 | 0 | 0 | 0 |
| b21 | 0 | 0 | 0 | 1 | 0 | 0 |
| b22 | 0 | 0 | 0 | 0 | 0 | 1 |

×

x 2600

| | 6:00~6:30 | | | 6:30~7:00 | | |
|---|---|---|---|---|---|---|
| | link1 | link2 | link3 | link1 | link2 | link3 |
| LINK FLOW | 285.5 | 315.5 | 916.5 | 285.5 | 315.5 | 916.5 |

# FIG. 29

Δy     2900

| TIME | OBSERVE | LINK FLOW |
|------|---------|-----------|
| 6:00～6:30 | #1 | 14.5 |
| | #2 | -316.5 |
| 6:30～7:00 | #3 | -85.5 |
| | #4 | 383.5 |

=

y′     2901

| TIME | OBSERVE | LINK FLOW |
|------|---------|-----------|
| 6:00～6:30 | #1 | 300 |
| | #2 | 600 |
| 6:30～7:00 | #3 | 200 |
| | #4 | 1300 |

−

y     2800

| TIME | OBSERVE | LINK FLOW |
|------|---------|-----------|
| 6:00～6:30 | #1 | 285.5 |
| | #2 | 916.5 |
| 6:30～7:00 | #3 | 285.5 |
| | #4 | 916.5 |

# FIG. 30

3000

q

| # | <ORIGIN, DESTINATION> | 6:00~ 6:30 | 6:30~ 7:00 |
|---|---|---|---|
| 1 | <node1, node4> | 134.5 | 434.75 |
| 2 | <node2, node4> | 157.25 | 507.25 |
| 3 | <node3, node4> | 157.25 | 507.25 |

=

Δq 3001

| # | <ORIGIN, DESTINATION> | 6:00~ 6:30 | 6:30~ 7:00 |
|---|---|---|---|
| 1 | <node1, node4> | -151 | 149.25 |
| 2 | <node2, node4> | -158.25 | 191.75 |
| 3 | <node3, node4> | -158.25 | 191.75 |

+

q 2201

| # | <ORIGIN, DESTINATION> | 6:00~ 6:30 | 6:30~ 7:00 |
|---|---|---|---|
| 1 | <node1, node4> | 285.5 | 285.5 |
| 2 | <node2, node4> | 315.5 | 315.5 |
| 3 | <node3, node4> | 315.5 | 315.5 |

# FIG. 31

2202

| # | <ORIGIN, DESTINATION> | 6:00~6:30 | 6:30~7:00 |
|---|---|---|---|
| 1 | <node1,node4> | 297 | 204 |
| 2 | <node2,node4> | 152 | 547 |
| 3 | <node3,node4> | 152 | 547 |

# FIG. 32

START

S3201
SET INITIAL OD FLOW

S3202
SET WIDTH OF FIRST TIME FRAME

S3203
SET TO FIRST OD FLOW

S3204
PERFORM FIRST TRAFFIC SIMULATION

S3205
CALCULATE LINK FLOW (TRAFFIC VOLUME)

S3206
EXTRACT OBSERVABLE LINK FLOW (TRAFFIC VOLUME)

S3207
CALCULATE LINK FLOW ERROR

S3208
IS ERROR WITHIN ALLOWABLE RANGE?

NO
S3209
CALCULATE CORRECTION VALUE

S3210
UPDATE FIRST OD FLOW

YES
S3211
DETERMINE OD FLOW FOR EACH FIRST TIME FRAME

S3212
DISTRIBUTE OD FLOW FOR EACH SECOND TIME FRAME

A

# FIG. 33

A

S3301
SET INITIAL OD FLOW

S3302
SET WIDTH OF SECOND TIME FRAME

S3303
SET TO SECOND OD FLOW

S3304
PERFORM SECOND TRAFFIC SIMULATION

S3305
CALCULATE LINK FLOW (TRAFFIC VOLUME)

S3306
EXTRACT OBSERVABLE LINK FLOW (TRAFFIC VOLUME)

S3307
CALCULATE LINK FLOW ERROR

S3308
IS ERROR WITHIN ALLOWABLE RANGE?

YES

NO

S3309
CALCULATE CORRECTION VALUE OF OD FLOW

S3310
UPDATE OD FLOW

S3311
DETERMINE OD FLOW FOR EACH SECOND TIME FRAME

S3312
OUTPUT OD FLOW

END

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 5 374067 B2 (TOYOTA CENTRAL RES & DEV; TOYOTA MOTOR CORP) 25 December 2013 (2013-12-25) * abstract * ----- | 1-9 | INV. G08G1/01 |

TECHNICAL FIELDS SEARCHED (IPC)

G08G
G06F

The present search report has been drawn up for all claims

| Place of search | Date of completion of the search | Examiner |
|---|---|---|
| The Hague | 22 October 2024 | Simigliani, V |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

................................................................

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 24 17 4787

This annex lists the patent family members relating to the patent documents cited in  the above-mentioned European search report.
The members are as contained in the European Patent Office EDP file on
The European Patent Office is in no way liable for these particulars which are merely given for the purpose of information.

22-10-2024

| Patent document cited in search report | | Publication date | Patent family member(s) | | Publication date |
|---|---|---|---|---|---|
| JP 5374067 | B2 | 25-12-2013 | JP | 5374067 B2 | 25-12-2013 |
| | | | JP | 2009259158 A | 05-11-2009 |

For more details about this annex : see Official Journal of the European Patent Office, No. 12/82

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2009259158 A

**Non-patent literature cited in the description**

• **WEI MA ; XIDONG PI ; SEAN QIAN.** Estimating multi-class dynamic origin-destination demand through a forward-backward algorithm on computational graphs. *Transportation Research Part C,* 2020, vol. 119, 102747